# EUROPEAN PATENT APPLICATION

(11) **EP 4 386 482 A1**
(43) Date of publication of application: **19.06.2024**
(21) Application number: 22856301.1
(22) Date of filing: 12.08.2022
(51) Int. Cl.: G03F 7/09, G03F 7/004, G03F 7/16, G03F 7/11

(54) **MULTI-LAYERED MOLECULAR FILM PHOTORESIST HAVING MOLECULAR LINE STRUCTURE AND METHOD FOR MANUFACTURING SAME**

(30) Priority: 12.08.2021 KR 20210106631; 13.01.2022 KR 20220005166
(71) Applicant: IUCF-HYU (INDUSTRY-UNIVERSITY COOPERATION FOUNDATION HANYANG UNIVERSITY), Seoul 04763 (KR)
(72) Inventor: SUNG, Myung Mo, Seoul 06636 (KR); AHN, Jinho, Seoul 06274 (KR); BAK, Yeong Eun, Seoul 02604 (KR); JI, Hyeon Seok, Seoul 05066 (KR); LEE, Jae Hyuk, Seoul 08267 (KR)
(74) Representative: dompatent von Kreisler Selting Werner - Partnerschaft von Patent- und Rechtsanwälten mbB
(86) International application number: PCT/KR2022/012143
(87) International publication number: WO 2023/018308

(57) **Abstract**

A multilayer molecular film photoresist is provided. The multilayer molecular film photoresist comprises a plurality of molecular lines extending upwards above a substrate arranged in the horizontal direction. Each of the molecular lines includes a plurality of inorganic single molecules and an organic single molecule sandwiched between at least some of the inorganic single molecules, and these single molecules are connected by bonds.

## Description

### [Technical Field]

The present invention relates to a photoresist, and more particularly, to a photoresist for EUV.

### [Background Art]

Research has been continuously conducted on photoresists, and in particular, the method of producing a liquid photoresist and then depositing it on a substrate by spin coating has been most actively studied. As such traditional photoresist, chemically amplified resist (CAR) containing polymer resin, PAG (Photo-Acid Generator), and base (quencher) is mainly used.

Recently, the semiconductor industry is introducing extreme ultraviolet (EUV) photolithography, which uses an EUV light source capable of forming ultra-fine patterns of 10 nm or less.

However, EUV has a low photon density of 1/14 compared to deep UV (DUV) of 193 nm, so it can cause stochastic failure, specifically chemical stochastic failure. For example, in the case of the CAR, shot noise may occur due to low probability of PAG participating in the reaction due to low photon density. In addition, CAR is known to have the disadvantage of exhibiting relatively large line edge roughness because the size of the polymer resin particles is larger than 4 nm.

### [Disclosure]

### [Technical Problem]

Therefore, the problem to be solved by the present invention is to provide a photoresist with excellent photon absorption and low line edge roughness.

The technical problems of the present invention are not limited to the technical problems mentioned above, and other technical problems not mentioned will be clearly understood by those skilled in the art from the following description.

### [Technical Solution]

According to one embodiment of the present invention, a multilayer molecular film photoresist is provided. The multilayer molecular film photoresist has a plurality of molecular lines arranged in the horizontal direction. Each of the molecular lines extends upwards above a substrate. Each molecular line includes a plurality of inorganic single molecules and an organic single molecule sandwiched between at least some of the inorganic single molecules, and these single molecules are connected by bonds.

Van der Waals interaction may exist between the organic single molecules in horizontally adjacent molecular lines among the molecular lines. The van der Waals interaction may be a π-π bond.

Within the each molecular line, the inorganic single molecules and the organic single molecules may be alternately stacked and connected by bonds.

Among the inorganic single molecules provided in the molecular lines, identical inorganic single molecules are located at the same level in the horizontal direction to form an inorganic monomolecular layer. Among the organic single molecules provided in the molecular lines, identical organic single molecules are located at the same level in the horizontal direction to form an organic monomolecular layer.

The multilayer molecular film photoresist may have at least one layer of a light-absorbing layer including light-absorbing inorganic single molecules, a photoreactive layer including photoreactive inorganic single molecules, and an etch-resistant layer including etch-resistant inorganic single molecules. The light-absorbing inorganic single molecule may be an inorganic single molecule having a metal element having a d orbital. The metal element having the d orbital may be Sn, Sb, Te, or Bi. The photoreactive inorganic molecule may have a metal element such as Zr, Al, Hf, Zn, or In. The etch-resistant inorganic single molecule may have a metal element such as Al, Ti, W, Zn, or Cu.

According to one embodiment of the present invention, another example of a multilayer molecular film photoresist is provided. The multilayer molecular film photoresist has a plurality of molecular lines arranged in the horizontal direction. The molecular lines each extend upwards above a substrate. Each of the molecular lines has a portion represented by the following Formula 1.

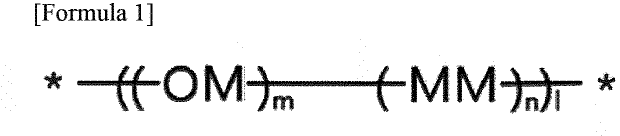

In Formula 1, one of the *s may be a bond with a functional group in a underlying portion, the other may be a bond with a functional group in an upper portion, MM may be an inorganic single molecule containing a metal element, OM may be an organic single molecule, and m may be 1 to 2, n may be 1 to 2, and l may be 1 to 1000.

The organic single molecule may be represented by the following Formula 3.

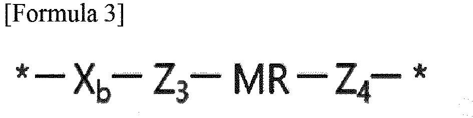

In Formula 3, one of the *s may be a bond with a functional group in an underlying portion, the other may be a bond with a functional group in an upper portion. X_{b} may be O, S, Se, NR (R may be H or CH₃) or PR (R may be H or CH₃). MR may be a substituted or unsubstituted aromatic ring, a C1 to C18 substituted or unsubstituted linear alkylene group, or a C1 to C18 substituted or unsubstituted branched alkylene group. When MR is the aromatic ring, Z₃ and Z₄, regardless of each other, may be a bond, a substituted or unsubstituted linear alkylene group of C1 to C5, or a substituted or unsubstituted branched alkylene group of C1 to C5. When MR is the alkylene group, Z₃ and Z₄ may be bonds.

In Formula 1, MM may be a light-absorbing inorganic single molecule containing a metal element having a d orbital, a photoreactive inorganic single molecule containing Zr, Al, Hf, Zn, or In, or an etch-resistant inorganic single molecule containing Al, Ti, Cu, W, or Zn.

The layer represented by Formula 1 may be a layer represented by Formula 1A below.

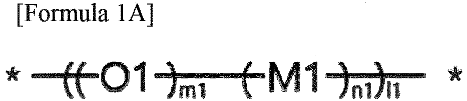

In Formula 1A, one of the *s may be a bond to a functional group in an underlying layer, and the other one may be a bond to a functional group in an upper layer. M1 may be a light-absorbing inorganic single molecule containing a metal element having a d orbital. O1 may be an organic single molecule, m1 may be 1 to 2, n1 may be 1 to 2, and l1 may be 1 to 1000.

Each of the molecular lines may have a layer represented by the following Formula 1B above or below the layer represented by the Formula 1A.

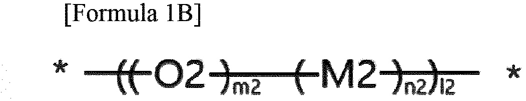

In Formula 1B, one of the *s may be a bond to a functional group in an underlying layer, and the other one may be a bond to a functional group in an upper layer. M2 may be a photoreactive inorganic single molecule containing Zr, Al, Hf, Zn, or In. O2 may be an organic single molecule. m2 may be 1 to 2, n2 may be 1 to 2, and l2 may be 1 to 1000.

Each of the molecular lines may have a layer represented by the following Formula 1C above or below the layer represented by the Formula 1A.

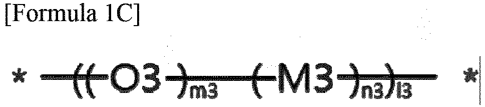

In Formula 1C, one of the *s may be a bond to a functional group in an underlying layer, and the other one may be a bond to a functional group in an upper layer. M3 may be a etch-resistant inorganic single molecule containing Al, Ti, Cu, W, or Zn. O3 may be an organic single molecule. m3 may be 1 to 2, n3 may be 1 to 2, and l3 may be 1 to 1000.

The multilayer molecular film photoresist may be a photoresist for EUV.

According to another embodiment of the present invention, multilayer molecular film photoresist deposition equipment may be provided. The multilayer molecular film photoresist deposition equipment may provide a multilayer molecular film photoresist including a plurality of molecular lines arranged in the horizontal direction. The molecular lines each extend upwards above a substrate. The multilayer molecular film photoresist is formed by performing multiple cycles including forming a metal monomolecular layer and forming an organic molecular layer on the substrate, thereby each of the molecular lines having a portion represented by the following Formula 1.

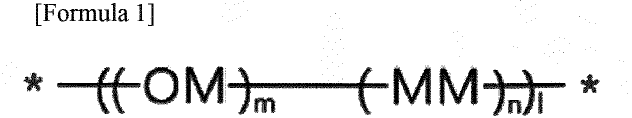

In Formula 1, one of the *s may be a bond with a functional group in a underlying portion, the other may be a bond with a functional group in an upper portion, MM may be an inorganic single molecule containing a metal element, OM may be an organic single molecule, and m may be 1 to 2, n may be 1 to 2, and l may be 1 to 1000.

The organic single molecule may be represented by the following Formula 3.

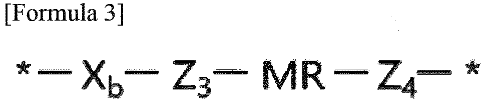

In Formula 3, one of the *s may be a bond with a functional group in an underlying portion, the other may be a bond with a functional group in an upper portion. X_{b} may be O, S, Se, NR (R may be H or CH₃) or PR (R may be H or CH₃). MR may be a substituted or unsubstituted aromatic ring, a C1 to C18 substituted or unsubstituted linear alkylene group, or a C1 to C18 substituted or unsubstituted branched alkylene group. When MR is the aromatic ring, Z₃ and Z₄, regardless of each other, may be a bond, a substituted or unsubstituted linear alkylene group of C1 to C5, or a substituted or unsubstituted branched alkylene group of C1 to C5. When MR is the alkylene group, Z₃ and Z₄ may be bonds.

In Formula 1, MM may be a light-absorbing inorganic single molecule containing a metal element having a d orbital, a photoreactive inorganic single molecule containing Zr, Al, Hf, Zn, or In, or an etch-resistant inorganic single molecule containing Al, Ti, Cu, W, or Zn.

### [Advantageous Effects]

In the multilayer molecular film photoresist according to an embodiment of the present invention, molecular lines, not particles, may be separated during exposure and development. Accordingly, Line Edge Roughness (LER), which refers to the lateral roughness of the pattern, can be very low for example at 1.2 nm or less, and resolution can also be greatly improved for example to 6 nm or less.

In addition, in one example, the multilayer molecular film photoresist includes a light-absorbing inorganic single molecule having an inorganic atom with a very high light absorption rate for EUV, specifically a metal atom with a 4d or 5d orbital, and thus it can exhibit high photosensitivity (ex. 10 mJ/cm²) with low stochastic failure even for EUV, which has a low photon density.

### [Description of Drawings]

FIG. 1 is a schematic diagram showing a multilayer molecular film photoresist having a vertical molecular line structure according to an embodiment of the present invention.
FIG. 2 is a schematic diagram showing another example of a light-absorbing layer among the multilayer molecular film photoresist having a vertical molecular line structure according to an embodiment of the present invention.
FIGs. 3 to 7 are schematic diagrams sequentially showing a photolithography method according to an embodiment of the present invention.
FIG. 8 shows a unit cycle configuration for forming an inorganic molecular layer.
FIG. 9 is an SEM image taken after patterning the vertically designed inorganic multilayer molecular film photoresist formed with reference to FIG. 8.
FIG. 10 shows an example of a unit cycle configuration for forming a multilayer molecular film photoresist having a vertical molecular line structure.
FIGs. 11a, 11b, and 11c are SEM images taken after patterning the photoresist formed using the method described with reference to FIG. 10.
FIG. 12 is a graph showing the sensitivity to electron beam of the photoresist formed using the method described with reference to FIG. 10.
FIG. 13a is a schematic diagram showing the form and dose conditions of EUV irradiation, and FIG. 13b shows an optical photograph of a photoresist pattern obtained when EUV as shown in FIG. 13a is irradiated to a photoresist using an Hf precursor formed using the method described with reference to FIG. 10.
FIG. 14a is an AFM (atomic force microscopy) image obtained after electron beam exposure and development of a photoresist using a Zn precursor formed using the method described with reference to FIG. 10, and FIG. 14b is an AFM (atomic force microscopy) image obtained after electron beam exposure and development of a PMMA photoresist.

### [Modes of the Invention]

In this specification, metal may include all metals, but as an example, it may be a transition metal, a post-transition metal, or a metalloid.

In this specification, the radiation may be EUV or E-beam, as an example. However, in some cases, it is not limited to this.

In this specification, a single molecule refers to a molecule that is not a polymer, and as an example, the single molecule refers to a small molecule, specifically, a molecule having 100 or less atoms, and specifically, 30 or less atoms.

In this specification, molecules or functional groups "connected by a bond" may mean that they are directly connected or indirectly connected by placing other molecule(s) or functional group between them.

In this specification, when "CX to CY" is written in this specification, it should be interpreted as the numbers corresponding to all integers between carbon number X and carbon number Y are also written. For example, when C1 to C10 are described, it should be interpreted as C1, C2, C3, C4, C5, C6, C7, C8, C9, and C10 are all described.

In this specification, when "X to Y" is written in this specification, it should be interpreted as the numbers corresponding to all integers between X and Y are also written. For example, when 1 to 10 are written, it should be interpreted as 1, 2, 3, 4, 5, 6, 7, 8, 9, and 10 are all written.

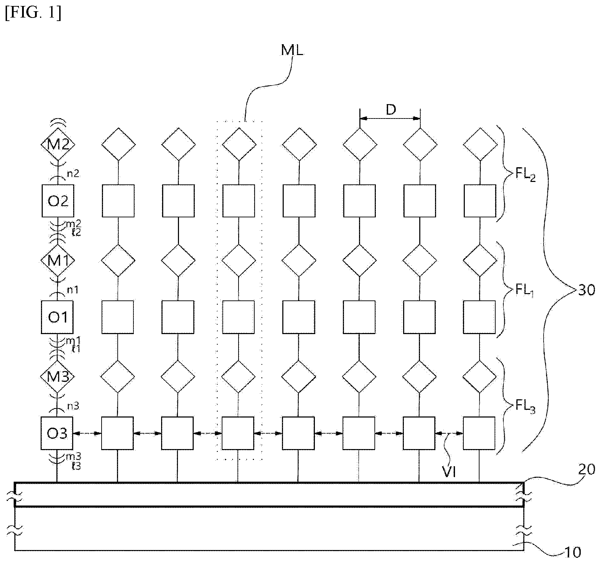

FIG. 1 is a schematic diagram showing a multilayer molecular film photoresist having a vertical molecular line structure according to an embodiment of the present invention.

Referring to FIG. 1, a substrate 10 may be provided. The substrate may be a bare substrate such as a semiconductor substrate, a glass substrate, or a flexible substrate. For example, the flexible substrate may be a polymer substrate. On the substrate, at least one device (not shown) such as a transistor, memory, diode, solar cell, optical device, biosensor, nanoelectromechanical system (NEMS), microelectromechanical system (MEMS), nanodevice, or chemical sensor may have been formed. The device may be an organic electronic device such as an organic light-emitting diode or an organic solar cell. As such, in this embodiment, the substrate 10 may be the bare substrate, or a substrate including the device formed on the bare substrate.

An etch target layer 20 may be formed on the substrate 10. The etch target layer 20 is a layer that will be etched to form a pattern using a photoresist pattern as an etch mask after forming the photoresist pattern on the layer 20, and may be formed of various materials used in the semiconductor process. As an example, the etch target layer 20 may be a metal film, a semiconductor film, an insulating film, or a composite film containing any one of these. The metal film is used to form wiring, and may be aluminum, tungsten, titanium, or a composite film containing any one of these. The semiconductor film may be a silicon film, for example, a single crystal silicon film, a polysilicon film, an amorphous silicon film, or a composite film containing any one of these. The insulating film may include an inorganic insulating film such as a silicon oxide film or a silicon nitride film; an organic insulating film such as an amorphous carbon film; or a composite film containing any one of these. In one example, the etch target layer 20 may be the bare substrate.

The etch target layer 20 may have a hydroxyl group, a thiol group, an amine group, or a phosphine group as an example of a surface functional group, or may be surface-treated to have the same.

A multilayer molecular film photoresist 30 having a molecular line structure may be formed on the etch target layer 20.

The multilayer molecular film photoresist 30 may include a plurality of molecular lines ML adjacent to each other in the horizontal direction. Each molecular line ML includes inorganic single molecules (M1, M2, or M3) connected directly or indirectly by bonds. The indirect connection may mean that another single molecule, for example, an organic single molecule (O1, O2, or O3), which will be described later, or a functional group is bonded between the inorganic single molecules (M1, M2, or M3). The bond may be a covalent bond or a coordinate bond. In one example, the molecular lines ML may extend upward over the substrate 10, for example, may extend in a vertical direction with respect to the substrate 10. The horizontal direction may be a direction substantially parallel to the surface of the substrate 10.

In this embodiment, the multilayer molecular film photoresist 30 is formed using Atomic Layer Deposition or Molecular Layer Deposition, so that almost all molecular lines ML in the multilayer molecular film photoresist 30 may have substantially the same stacked structure. As a result, the molecular lines ML in the multilayer molecular film photoresist 30 may have substantially the same inorganic single molecules located at the same level and substantially the same organic single molecules located at the same level. The inorganic single molecules located at the same level of the molecular lines ML in the horizontal direction may form an inorganic monomolecular layer; and the organic single molecules located at the same level of the molecular lines ML in the horizontal direction may form an organic monomolecular layer.

The multilayer molecular film photoresist 30 may be an organic/inorganic multilayer molecular film photoresist. Specifically, each molecular line ML in the multilayer molecular film photoresist 30 may have an organic single molecule 01, 02, O3 interposed and bonded between some of the inorganic single molecules M1, M2, M3. In this case, the multilayer molecular film photoresist 30 may include a plurality of molecular lines ML adjacent to each other in the horizontal direction, and each molecular line ML includes organic single molecules O1, O2, O3 and inorganic single molecules M1, M2, M3 connected by bonding. The multilayer molecular film photoresist 30 may have a van der Waals interaction VI between organic single molecules O1, O2, O3 in adjacent molecular lines ML among the molecular lines ML. The van der Waals interaction VI can play a role in stabilizing the horizontally adjacent molecular lines ML and preventing the pattern formed later from collapsing even when it has a high aspect ratio. In one example, the van der Waals interaction may be a π-π interaction between aromatic groups.

The multilayer molecular film photoresist 30 may have a structure represented by the following Formula 1.

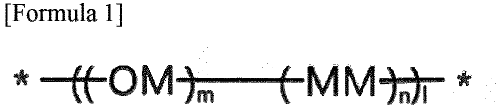

In Formula 1, one of the *s may be a bond to a functional group in an underlying layer or a functional group in an underlying single molecule, and the other one may be a bond to a functional group in an upper layer or a functional group in an upper single molecule. The bond may be, for example, a covalent bond. OM may be an organic single molecule. Specifically, the OM may be an organic single molecule represented by Formula 3 below. In Formula 1, m may be 0 to 10, n may be 1 to 10, and l may be 1 to 10000, specifically 20 to 1000, and more specifically 25 to 100. Specifically, m may be 1 to 2, and as an example, m may be 1. n may also be 1 to 2, for example, n may be 1.

MM may be an inorganic single molecule containing a metal element, specifically an organometallic single molecule. As an example, MM is a light-absorbing inorganic single molecule containing a metal element having a d orbital, a photoreactive inorganic single molecule containing Zr, Al, Hf, Zn, or In, or an etch-resistant inorganic single molecule containing Al, Ti, Cu, W, or Zn. The metal element having the d orbital, specifically 4d or 5d orbital, may be Sn, Sb, Te, or Bi. Although inorganic single molecules have been classified by distinct functions, all of the described inorganic single molecules are capable of light-absorbing and photoreaction. The MM may be an organometallic single molecule represented by the following Formula 2, specifically the following Formulas 2A, 2B, or 2B.

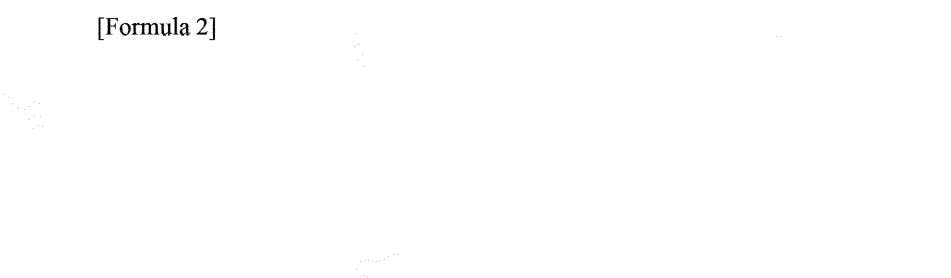

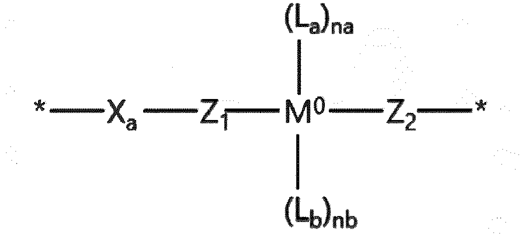

In Formula 2, one of the *s may be a bond with a functional group in an underlying layer or a functional group in an underlying single molecule, and the other one may be a bond with a functional group in an upper layer or a functional group in an upper single molecule. The bond may be, for example, a covalent bond.

Z₁ and Z₂ may be, regardless of each other, a bond, a substituted or unsubstituted linear or branched alkylene group of C1 to C20, a substituted or unsubstituted linear or branched alkyleneoxide of C 1 to C20, a substituted or unsubstituted linear or branched alkyleneamino of C1 to C20, a substituted or unsubstituted linear or branched alkylenesilylamino of C 1 to C20, a substituted or unsubstituted linear or branched alkylenethio of C 1 to C20, a substituted or unsubstituted linear or branched alkyleneseleno of C1 to C20, or a substituted or unsubstituted linear or branched alkylenephosphino of C1 to C20. M⁰ may be a light-absorbing metal atom having a d orbital, a photoreactive metal atom of Zr, Al, Hf, Zn, or In, or an etch-resistant metal atom ofAl, Ti, Cu, W, or Zn. The metal element having the d orbital, specifically a 4d or 5d orbital, may be Sn, Sb, Te, or Bi. Xₐ may be O, S, Se, NR (R may be H or CH₃) or PR (R may be H or CH₃).

Lₐ and L_{b} are ligands bound to M⁰. The sum of na and nb, the number of Lₐ and L_{b}, may be determined by the coordination number of M⁰. For example, the sum of na and nb may be an integer from 1 to 4. Lₐ and L_{b}, regardless of each other, may be a halogen group (ex. Cl, Br, or I), a C1 to C5 alkyl group, a C1 to C5 alkylsilylamino group, a C 1 to C5 alkoxy group, a C 1 to C5 alkylthio group, a C 1 to C5 alkylseleno group, a C1 to C5 alkylamino group, or a C1 to C5 alkylphosphino group. The C1 to C5 alkyl groups may be substituted or unsubstituted, linear or branched alkyl groups. Additionally, in Formula 2, when na and/or nb are 2 or more, Lₐ and/or L_{b} may be selected, regardless of each other, among the above examples. In one example, when the sum of na and nb is 2 or more, two of Lₐ and L_{b} may be combined with M⁰ to which they are attached to form heterocyclyl or heteroaryl. Each bond between Z₁, Z₂, Lₐ, or L_{b} and M⁰ may be covalent or coordinate bond, regardless of the other.

In one example, the multilayer molecular film photoresist 30 may have at least one of a light-absorbing layer FL₁, a photoreactive layer FL₂, and an etch-resistant layer FL₃, which are classified according to the type of the inorganic single molecule, specifically the organometallic single molecule. The classification of each layer may refer to a distinct main function, but all layers may generate secondary electrons due to light-absorbing and perform a photoreaction described later. As an example, the multilayer molecular film photoresist 30 may include at least a light-absorbing layer FL₁. The stacking order of the light-absorbing layer FL₁, the photoreactive layer FL₂, and the etch-resistant layer FL₃ may vary depending on the type of the etch target layer 20 and/or the type of pattern to be formed through photolithography.

The light-absorbing layer FL₁ may have excellent absorption of radiation, specifically EUV or E-beam, and may generate secondary electrons after absorbing the radiation. The light-absorbing layer FL₁ may have a structure represented by the following Formula 1A.

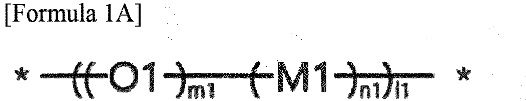

In Formula 1A, one of the *s may be a bond to a functional group in an underlying layer or a functional group in an underlying single molecule, and the other one may be a bond to a functional group in an upper layer or a functional group in an upper single molecule. The bond may be, for example, a covalent bond. M1 may be a light-absorbing inorganic single molecule, for example, an organometallic single molecule containing a metal element having a d orbital, specifically a 4d or 5d orbital. The metal element may be Sn, Sb, Te, or Bi. O1 may be an organic single molecule. m1 may be 0 to 10, n1 may be 1 to 10, and 11 may be 1 to 1000. Specifically, m1 may be 1 to 2, and as an example, m1 may be 1. n1 may also be 1 to 2, and as an example, n1 may be 1.

The light-absorbing inorganic single molecule M1 may be a light-absorbing organometallic single molecule represented by the following Formula 2A, and when n1 is 2 or more or l1 is 2 or more in the Formula 1A, the light-absorbing inorganic single molecule M1 of each layer may be the same or different from each other.

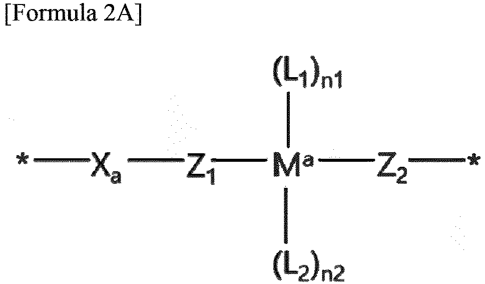

In Formula 2A, one of the *s may be a bond with a functional group in an underlying layer or a functional group in an underlying single molecule, and the other one may be a bond with a functional group in an upper layer or a functional group in an upper single molecule. The bond may be, for example, a covalent bond. Z₁ and Z₂ may be, regardless of each other, a bond, a substituted or unsubstituted linear or branched alkylene group of C1 to C20, a substituted or unsubstituted linear or branched alkyleneoxide of C1 to C20, a substituted or unsubstituted linear or branched alkyleneamino of C1 to C20, a substituted or unsubstituted linear or branched alkylenesilylamino of C 1 to C20, a substituted or unsubstituted linear or branched alkylenethio of C 1 to C20, a substituted or unsubstituted linear or branched alkyleneseleno of C1 to C20, or a substituted or unsubstituted linear or branched alkylenephosphino of C1 to C20. M^{a} may be an inorganic atom with excellent absorption of radiation, specifically EUV or E-beam. For example, M^{a} may be a metal atom having a d orbital, specifically, a 4d or 5d orbital. The metal atom may be Sn, Bi, Sb, or Te. Xₐ may be O, S, Se, NR (R may be H or CH₃) or PR (R may be H or CH₃).

In Formula 2A, L₁ and L₂ are ligands bound to M^{a}. The sum of n1 and n2, the number of L₁ and L₂, may be determined by the coordination number of M^{a}. For example, the sum of n1 and n2 may be an integer from 1 to 4. L₁ and L₂, regardless of each other, may be a halogen group (ex. Cl, Br, or I), a C1 to C5 alkyl group, a C1 to C5 alkylsilylamino group, a C1 to C5 alkoxy group, a C1 to C5 alkylthio group, a C1 to C5 alkylseleno group, a C1 to C5 alkylamino group, or a C1 to C5 alkylphosphino group. The C1 to C5 alkyl groups may be substituted or unsubstituted, linear or branched alkyl groups. Additionally, in Formula 2A, when n1 and/or n2 are 2 or more, L₁ and/or L₂ may be selected, regardless of each other, among the above examples. In one example, when the sum of n1 and n2 is 2 or more, two of L₁ and L₂ may be combined with M^{a} to which they are attached to form heterocyclyl or heteroaryl. Each bond between Z₁, Z₂, L₁, or L₂ and M^{a} may be covalent or coordinate bond, regardless of the other.

The organic single molecule O1 may be represented by Formula 3, and when m1 is 2 or more or 11 is 2 or more in Formula 1A, the organic single molecule O1 in each layer may be the same or different from each other.

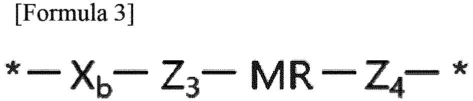

In Formula 3, one of the *s may be a bond with a functional group in an underlying layer or a functional group in an underlying single molecule, and the other one may be a bond with a functional group in an upper layer or a functional group in an upper single molecule. The bond may be, for example, a covalent bond. X_{b} may be O, S, Se, NR (R may be H or CH₃) or PR (R may be H or CH₃).

In one example, MR of Formula 3 may be a substituted or unsubstituted aromatic ring. Substitution may be that any hydrogen of the aromatic ring is replaced with any one of various functional groups. When MR is the aromatic ring, Z₃ and Z₄, regardless of each other, may be a bond, a substituted or unsubstituted C1 to C5 linear alkylene group, or a substituted or unsubstituted C 1 to C5 branched alkylene group. The substitution may be performed by replacing any hydrogen of the alkylene group with any one of various functional groups, such as OH, SH, SeH, NRz (two Rs may be H or CH₃ regardless of each other), or PR₂ (two Rs may be H or CH₃ regardless of each other).

In another example, MR of Formula 3 may be a substituted or unsubstituted linear or branched alkylene group of C1 to C18. The substitution may be performed by replacing any hydrogen of alkylene group with a functional group that can crosslink by radiation, for example, a functional group containing a vinyl group, or by replacing any hydrogen of alkylene group with any one of various functional groups, such as OH, SH, SeH, NR₂ (two Rs may be H or CH₃ regardless of each other), PR₂ (two Rs may be H or CH₃ regardless of each other). When MR is an alkylene group, Z₃ and Z₄ may be bonds.

The multilayer molecular film photoresist 30 may include a photoreactive layer FL₂ in addition to the light-absorbing layer FL₁. The photoreactive layer FL₂ may have a layer structure represented by the following Formula 1B.

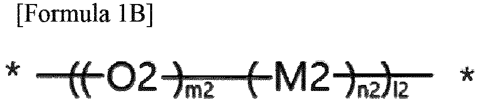

In Formula 1B, one of the *s may be a bond to a functional group in an underlying layer or a functional group in an underlying single molecule, and the other one may be a bond to a functional group in an upper layer or a functional group in an upper single molecule. The bond may be, for example, a covalent bond. M2 may be a photoreactive inorganic single molecule, specifically an organometallic single molecule containing Zr, Al, Hf, Zn, or In. O2 may be an organic single molecule. m2 may be 0 to 10, n2 may be 1 to 10, and l2 may be 1 to 1000. Specifically, m2 may be 1 to 2, for example, m2 may be 1. n2 may also be 1 to 2, for example, n2 may be 1.

The photoreactive inorganic single molecule M2 may be a photoreactive organometallic single molecule represented by the following Formula 2B, and when n2 is 2 or more or l2 is 2 or more in the Formula 1B, the photoreactive inorganic single molecule M2 of each layer may be the same or different from each other.

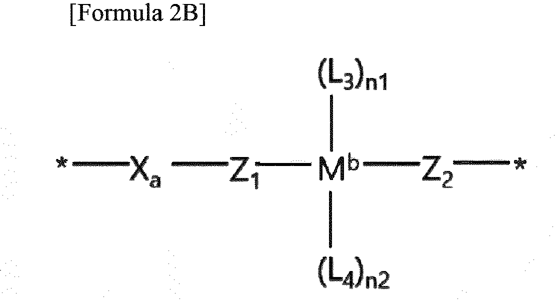

In Formula 2B, one of the *s may be a bond with a functional group in an underlying layer or a functional group in an underlying single molecule, and the other one may be a bond with a functional group in an upper layer or a functional group in an upper single molecule. The bond may be, for example, a covalent bond. Z₁ and Z₂ may be, regardless of each other, a bond, a substituted or unsubstituted linear or branched alkylene group of C1 to C20, a substituted or unsubstituted linear or branched alkyleneoxide of C1 to C20, a substituted or unsubstituted linear or branched alkyleneamino of C1 to C20, a substituted or unsubstituted linear or branched alkylenesilylamino of C 1 to C20, a substituted or unsubstituted linear or branched alkylenethio of C 1 to C20, a substituted or unsubstituted linear or branched alkyleneseleno of C1 to C20, or a substituted or unsubstituted linear or branched alkylenephosphino of C1 to C20. M^{b} may be a metal atom, specifically, Zr, Al, Hf, Zn, or In. Xₐ may be O, S, Se, NR (R may be H or CH₃) or PR (R may be H or CH₃).

L₃ and L₄ are ligands bound to M^{b}. The sum of n1 and n2, the number of L₃ and L₄, may be determined by the coordination number of M^{b}. For example, the sum of n1 and n2 may be an integer from 1 to 4. L₃ and L₄, regardless of each other, may be a halogen group (ex. Cl, Br, or I), a C1 to C5 alkyl group, a C1 to C5 alkylsilylamino group, a C1 to C5 alkoxy group, a C1 to C5 alkylthio group, a C1 to C5 alkylseleno group, a C1 to C5 alkylamino group, or a C1 to C5 alkylphosphino group. The C1 to C5 alkyl groups may be substituted or unsubstituted, linear or branched alkyl groups. Additionally, in Formula 2B, when n1 and/or n2 are 2 or more, L₃ and/or L₄ may be selected, regardless of each other, among the above examples. In one example, when the sum of n1 and n2 is 2 or more, two of L₃ and L₄ may be combined with M^{b} to which they are attached to form heterocyclyl or heteroaryl. Each bond between Z₁, Z₂, L₃, or L₄ and M^{b} may be covalent or coordinate bond, regardless of the other.

The organic single molecule O2 may be represented by Formula 3. However, it may be the same as or different from the organic single molecule O1 in the light-absorbing layer FL₁. When m2 is 2 or more or l2 is 2 or more in Formula 1B, the organic single molecule O2 in each layer may be the same or different from each other.

Crosslinks may be formed between the photoreactive inorganic single molecules M2 in adjacent molecular lines ML by secondary electrons generated in the light-absorbing layer FL₁ upon radiation exposure or generated from the metal included in the photoreactive inorganic single molecule M2 and/or in the etch-resistant inorganic single molecule M3 described below upon radiation exposure. Specifically, M^{b}-L₄ and L₃-M^{b} bonds between adjacent photoreactive inorganic single molecules M2 may react by the secondary electrons to form M^{b}-Y₂-M^{b} bond. This M^{b}-Y₂-M^{b} bond may not be etched by a developer, for example a developing gas or developing plasma, that develops a multilayer molecular film photoresist pattern formed by exposure. For this purpose, the type of M^{b} can be selected as above. Y₂ may be O, S, Se, N, or P.

However, it is not limited to this, and crosslinks may also be formed between the light-absorbing inorganic single molecules M1 in the adjacent molecular lines ML by secondary electrons generated during radiation exposure in the light-absorbing layer FL₁. Specifically, M^{a}-L₂ and L₁-M^{a} bonds between the adjacent light-absorbing inorganic single molecules M1 may react by the secondary electrons to form M^{a}-Y₁-M^{a} bonds. This M^{a}-Y₁-M^{a} bond may also not be etched by the developer. Y₁ may be O, S, Se, N, or P.

The multilayer molecular film photoresist 30 may include an etch-resistant layer FL₃ in addition to the light-absorbing layer FL₁. The etch-resistant layer FL₃ may have a layer structure represented by the following Formula 1C.

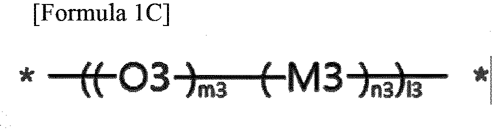

In Formula 1C, one of the *s may be a bond to a functional group in an underlying layer or a functional group in an underlying single molecule, and the other one may be a bond to a functional group in an upper layer or a functional group in an upper single molecule. The bond may be, for example, a covalent bond. M3 may be a etch-resistant inorganic single molecule, specifically an organometallic single molecule containing Al, Ti, Cu, W, or Zn. O3 may be an organic single molecule, m3 may be 0 to 10, n3 may be 1 to 10, and l3 may be 1 to 1000. Specifically, m3 may be 1 to 2, and as an example, m3 may be 1. n3 may also be 1 to 2, for example, n3 may be 1.

The etch-resistant inorganic single molecule M3 may be a etch-resistant organometallic single molecule represented by the following Formula 2C, and when n3 is 2 or more or l3 is 2 or more in the Formula 1C, the etch-resistant inorganic single molecule M3 of each layer may be the same or different from each other.

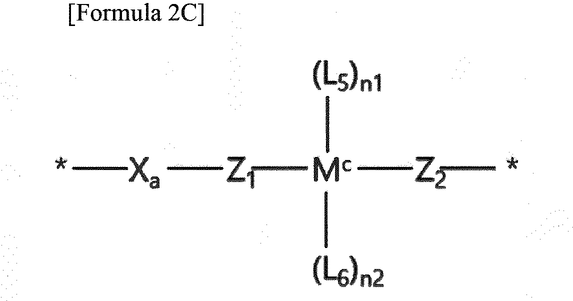

In Formula 2C, one of the *s may be a bond with a functional group in an underlying layer or a functional group in an underlying single molecule, and the other one may be a bond with a functional group in an upper layer or a functional group in an upper single molecule. The bond may be, for example, a covalent bond. Z₁ and Z₂ may be, regardless of each other, a bond, a substituted or unsubstituted linear or branched alkylene group of C1 to C20, a substituted or unsubstituted linear or branched alkyleneoxide of C1 to C20, a substituted or unsubstituted linear or branched alkyleneamino of C1 to C20, a substituted or unsubstituted linear or branched alkylenesilylamino of C1 to C20, a substituted or unsubstituted linear or branched alkylenethio of C1 to C20, a substituted or unsubstituted linear or branched alkyleneseleno of C1 to C20, or a substituted or unsubstituted linear or branched alkylenephosphino of C1 to C20. M^{c} may be a metal atom, specifically, Al, Ti, W, Zn, or Cu. Xₐ may be O, S, Se, NR (R may be H or CH₃) or PR (R may be H or CH₃).

L₅ and L₆ are ligands bound to M^{c}. The sum of n1 and n2, the number of L₅ and L₆, may be determined by the coordination number of M^{c}. For example, the sum of n1 and n2 may be an integer from 1 to 4. L₅ and L₆, regardless of each other, may be a halogen group (ex. Cl, Br, or I), a C1 to C5 alkyl group, a C1 to C5 alkylsilylamino group, a C1 to C5 alkoxy group, a C1 to C5 alkylthio group, a C1 to C5 alkylseleno group, a C1 to C5 alkylamino group, or a C1 to C5 alkylphosphino group. The C1 to C5 alkyl groups may be substituted or unsubstituted, linear or branched alkyl groups. Additionally, in Formula 2C, when n1 and/or n2 are 2 or more, L₅ and/or L₆ may be selected, regardless of each other, among the above examples. In one example, when the sum of n1 and n2 is 2 or more, two of L₅ and L₆ may be combined with M^{c} to which they are attached to form heterocyclyl or heteroaryl. Each bond between Z₁, Z₂, L₅, or L₆ and M^{c} may be covalent or coordinate bond, regardless of the other.

The organic single molecule O3 may be represented by Formula 3. However, it may be the same as or different from the organic single molecule O1 in the light-absorbing layer FL₁ or the organic single molecule O2 in the photoreactive layer FL₂. When m3 is 2 or more or l3 is 2 or more in Formula 1C, the organic single molecule O3 in each layer may be the same or different from each other.

Crosslinks may be formed between the etch-resistant inorganic single molecules M3 in adjacent molecular lines ML by secondary electrons generated in the light-absorbing layer FL₁ upon radiation exposure or generated from the metal included in the photoreactive inorganic single molecule M₂ and/or in the etch-resistant inorganic single molecule M₃ upon radiation exposure. Specifically, M^{c}-L₅ and L₆-M^{c} bonds between the adjacent etch-resistant inorganic single molecules M3 may react by the secondary electrons to form M^{c}-Y₃-M^{c} bond. This M^{c}-Y₃-M^{c} bond may not be etched by a developer, and may further not be etched by an etchant, for example plasma, for etching the etch target layer 20. For this purpose, the type of M^{c} can be selected as above. Y₃ may be O, S, Se, N, or P.

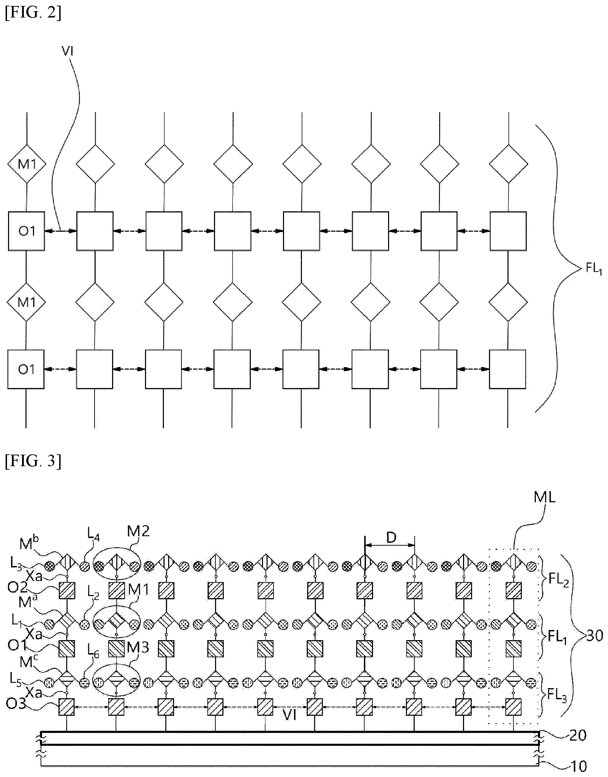

FIG. 2 is a schematic diagram showing another example of a light-absorbing layer in the multilayer molecular film photoresist having a vertical molecular line structure according to an embodiment of the present invention.

The light-absorbing layer FL₁ shown in FIG. 2 is a case in which m1 in FIG. 1 is 1, n1 in FIG. 1 is 1, and l1 in FIG. 1 is 2. Although the light-absorbing layer FL₁ is shown as an example in FIG. 2, the photoreactive layer FL₂ and/or the etch-resistant layer FL₃ of FIG. 1 may also have one of these exemplary structures.

As such, when m, m1, m2, m3 and n, n1, n2, and n3 in the Formulas 1, 1A, 1B, or 1C are all 1, the multilayer molecular film photoresist 30 may have a structure in which inorganic single molecules (MM, M1, M2, or M3) and organic single molecules (OM, O1, O2, or O3) are alternately stacked. In this case, the organic single molecule (OM, O1, O2, or O3) is placed between inorganic single molecules (MM, M1, M2, or M3), and both the inorganic single molecule (MM, M1, M2, or M3) and the organic single molecule (OM, O1, O2, or O3) can be self-assembled on the underlying layer or underlying single molecule. As a result, the molecular lines ML may extend upward, for example, vertically, with respect to the substrate 10 and may be spaced apart from each other.

FIGs. 3 to 7 are schematic diagrams sequentially showing a photolithography method according to an embodiment of the present invention. For convenience of explanation, FIGs. 3 to 7 illustrate the case where n1, n2, n3, m1, m2, m3, l1, l2, and l3 of FIG. 1 are all 1 in the multilayer molecular film photoresist 30 and the case where both Z₁ and Z₂ are bonds in Formulas 2A, 2B, and 2C, which represent inorganic single molecules M1, M2, M3, and all of n1 and n2 are 1.

Referring to FIG. 3, a substrate 10 on which a etch target layer 20 is formed may be provided. The substrate 10 and the etch target layer 20 may be the same as those described with reference to FIG. 1.

A multilayer molecular film photoresist 30 may be formed on the etch target layer 20. The multilayer molecular film photoresist 30 may be the same as the embodiment described with reference to FIG. 1 except as described later. In one embodiment, the multilayer molecular film photoresist 30 is described as an example in which an etch-resistant layer FL₃, a light-absorbing layer FL₁, and a photoreactive layer FL₂ are sequentially stacked, but is not limited thereto. The stacking order may vary depending on the type of the etch target layer 20 and/or the type of pattern to be formed through photolithography. The multilayer molecular film photoresist 30 can be formed using the atomic layer deposition equipment or molecular layer deposition equipment.

As an example, a light-absorbing layer FL₁ may be formed on the etch target layer 20. Forming the light-absorbing layer FL₁ can be performed using the atomic layer deposition method, specifically, the molecular layer deposition method.

In one example, the light-absorbing layer FL₁ may be formed by performing a cycle including forming a light-absorbing metal monolayer M1 and forming an organic molecular layer O1 multiple times (l1 in Formula 1A). In the step of forming the organic molecular layer O1, a unit cycle comprising an organic precursor dosing step of dosing an organic precursor and chemically bonding the organic precursor to the underlying layer through self-assembly; and a purge step of purging unreacted organic precursors and reaction by-products by supplying a purge gas may be performed. The purge gas may be argon.

In one example, the organic precursor may be represented by Formula 4 below.

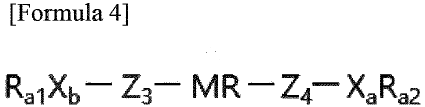

In Formula 4, Rₐ₁ and Rₐ₂ may be hydrogen or a C1 to C2 alkyl group regardless of each other, and X_{b} and Xₐ may be O, S, Se, NR (R may be H or CH₃) or PR (R may be H or CH₃) regardless of each other. Meanwhile, Z₃, Z₄, and MR are as defined in Formula 3 above.

Specific examples of the organic precursor may be as follows.

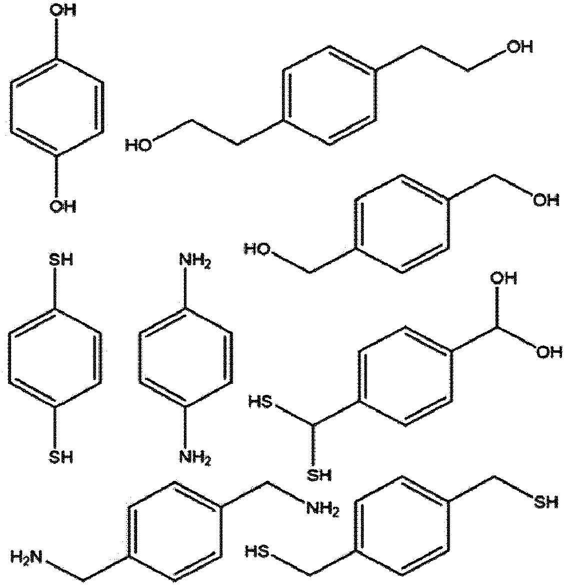

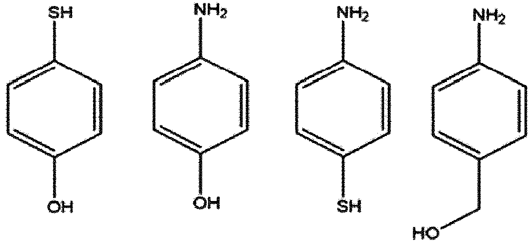

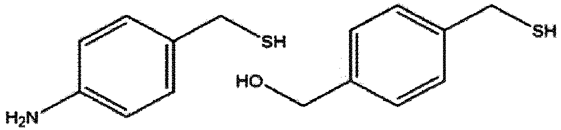

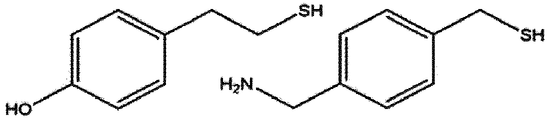

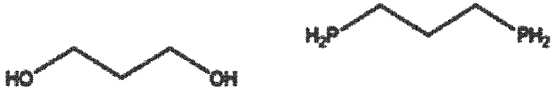

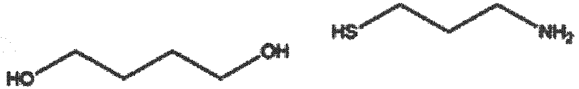

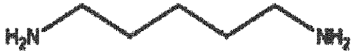

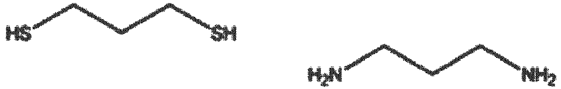

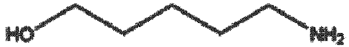

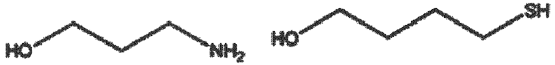

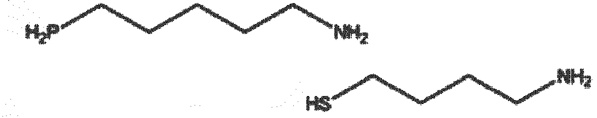

In the organic precursor dosing step, a reaction according to Scheme 1 below may occur.

[Scheme 1] -R₀+Rₐ₁X_{b}-Z₃-MR-Z₄-XₐRₐ₂→*-X_{b}-Z₃-MR-Z₄-XₐRₐ₂+R₀Rₐ₁

In Scheme 1, R₀ is a functional group on the surface of the underlying layer, and R₀ may be hydrogen, a hydroxy group, a thiol group, an amine group, a phosphine group, a C1 to C5 alkyl group, a C1 to C5 alkoxy, a C1 to C5 alkylthio group, a C1 to C5 alkylseleno group, a C1 to C5 alkylamine group, or a C1 to C5 alkylphosphino group. Rₐ₁X_{b}-Z₃-MR-Z₄-XₐRₐ₂ is an organic precursor, and each functional group is as defined in Formula 4 above.

Referring to Scheme 1, the organic precursor may self-assemble on an underlying layer by reacting with the functional group on the surface of the underlying layer. During this process, R₀Rₐ₁ may be generated as a reaction by-product. After this, remaining excess organic precursor and reaction by-products can be purged in the purge step.

In the step of forming a light-absorbing metal monolayer M1, a unit cycle comprising a metal precursor dosing step of dosing a metal precursor and chemically bonding the metal precursor to the underlying layer by self-assembly; and a purge step of purging unreacted metal precursors and reaction by-products by supplying a purge gas may be performed. The purge gas may be argon.

The metal precursor for forming the light-absorbing metal monolayer M1 may be represented by the following formula 5A.

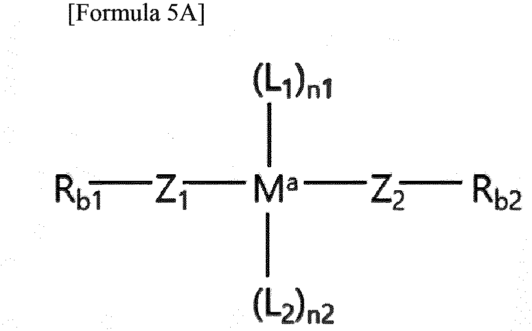

In Formula 5A, R_{b1} and R_{b2} may be, regardless of each other, a halogen group (ex. Cl, Br, or I), a C1 to C5 alkyl group, a C1 to C5 alkylsilylamino group, a C1 to C5 alkoxy group, a C1 to C5 alkylthio group, a C1 to C5 alkylseleno group, a C1 to C5 alkylamino group, or a C1 to C5 alkylphosphino group. The C1 to C5 alkyl groups may be substituted or unsubstituted linear or branched alkyl groups. Z₁, Z₂, L₁, L₂, n1, n2, and M^{a} are as defined in Formula 2A. In addition, in some cases, two of R_{b1}, R_{b2}, L₁, and L₂ may be combined with M^{a} to which they are directly or indirectly bonded to form heterocyclyl or heteroaryl. Alternatively, at least one of R_{b1} and R_{b2} may be coordinated to M^{a}.

Specific examples of metal precursors for forming the light-absorbing metal monolayer M1 may be as follows.

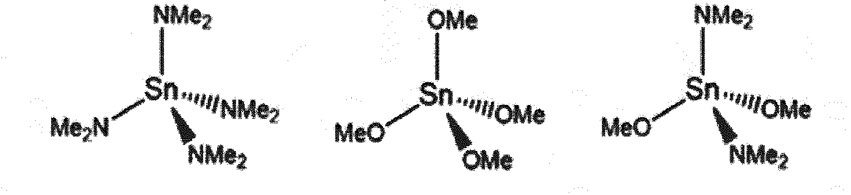

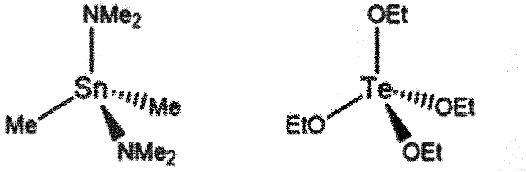

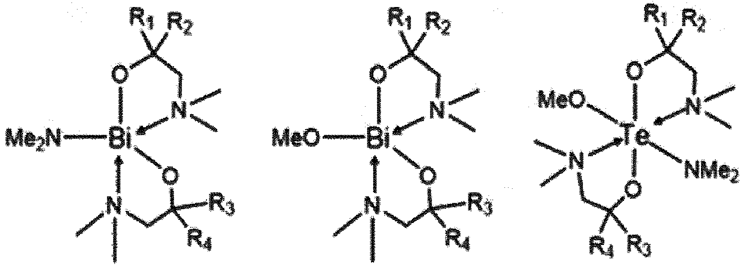

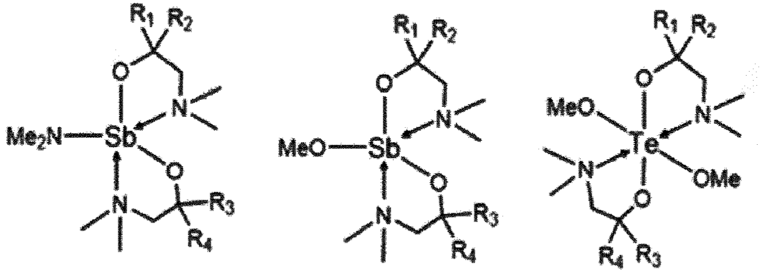

In the metal precursors, R₁, R₂, R₃, and R₄ may be C1 to C5 alkyl groups regardless of each other.

In the metal precursor dosing step, a reaction according to Scheme 2 below may occur.

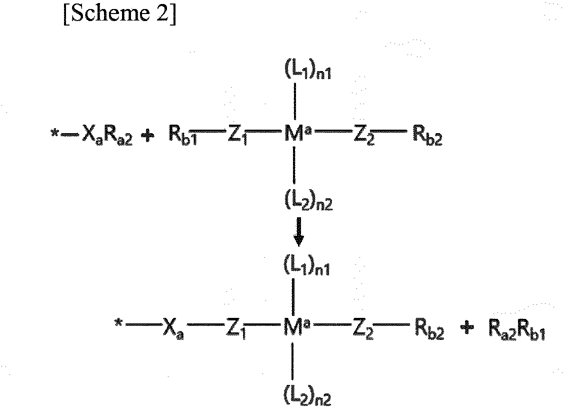

In Scheme 2, *-XₐRₐ₂ may be a surface functional group of the underlying layer, specifically, the surface functional group of the organic molecular layer O1 formed previously. The metal precursor of Formula 5A may self-assemble on the surface of the organic molecular layer O1 by reacting with the surface functional group of the previously formed organic molecular layer O1. During this process, Rₐ₂R_{b1} may be produced as a reaction by-product. After this, the remaining metal precursor and the reaction by-products may be purged in the purge step. In Scheme 2, each functional group may be the same as defined in Formula 4 and Formula 5A.

Unlike shown, when the light-absorbing layer FL₁ is formed of a plurality of metal monomolecular layers M1 (when n1 in Formula 1A is 2 or more), after performing the metal precursor dosing step and purge step according to Scheme 2 described above, a unit cycle comprising a reaction gas dosing step of dosing a reaction gas to react with the metal precursor chemically bonded to the underlying layer, a purge step of supplying a purge gas to purge unreacted reaction gas and reaction by-products, the metal precursor dosing step, and the purge step may be repeated. The reaction gas may be hydrogen, a gas containing oxygen (ex. Oz, O₃, H₂O), or a gas containing nitrogen (ex. NH₃).

A photoreactive layer FL₂ may be formed on the light-absorbing layer FL₁ or on the substrate before forming the light-absorbing layer FL₁. Forming the photoreactive layer FL₂ may be performed using the atomic layer deposition method, specifically, the molecular layer deposition method.

As an example, the photoreactive layer FL₂ may be formed by performing a cycle including forming a photoreactive metal monolayer M2 and forming an organic molecular layer O2. The organic molecular layer O2 may be formed using the same or similar method to the method of forming the organic molecular layer O1 described in the light-absorbing layer FL₁. However, in the organic precursor dosing step of Scheme 1, -R₀ may be replaced with -R_{b2}, which is the terminal group of the metal precursor self-assembled on the underlying layer described in Scheme 2.

The photoreactive metal monolayer M2 may be formed by performing a unit cycle including a metal precursor dosing step of dosing a metal precursor and chemically bonding the metal precursor to the underlying layer by self-assembly; and a purge step of purging unreacted metal precursors and reaction by-products by supplying a purge gas. The purge gas may be argon.

The metal precursor for forming the photoreactive metal monolayer M2 may be represented by the following formula 5B.

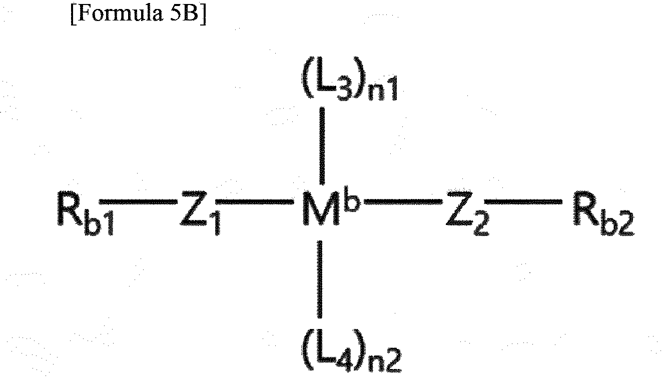

In Formula 5B, R_{b1} and R_{b2} may be, regardless of each other, a halogen group (ex. Cl, Br, or I), a C1 to C5 alkyl group, a C1 to C5 alkylsilylamino group, a C1 to C5 alkoxy group, a C1 to C5 alkylthio group, a C1 to C5 alkylseleno group, a C1 to C5 alkylamino group, or a C1 to C5 alkylphosphino group. The C1 to C5 alkyl groups may be substituted or unsubstituted linear or branched alkyl groups. Z₁, Z₂, L₃, L₄, n1, n2, and M^{b} are as defined in Formula 2B. In addition, in some cases, two of R_{b1}, R_{b2}, L₃, and L₄ may be combined with M^{b} to which they are directly or indirectly bonded to form heterocyclyl or heteroaryl. Alternatively, at least one of R_{b1} and R_{b2} may be coordinated to M^{b}.

Specific examples of metal precursors for forming the photoreactive metal monolayer M2 may be as follows.

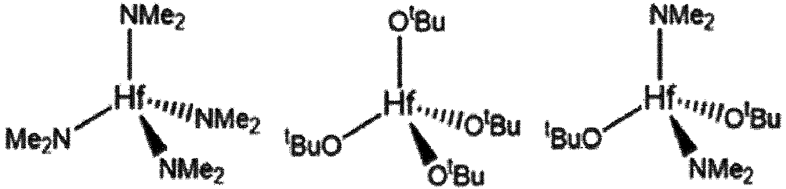

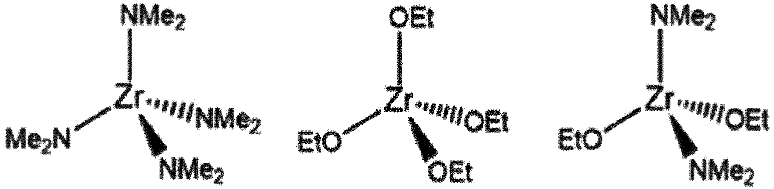

In the metal precursor dosing step, a reaction according to Scheme 3 below may occur.

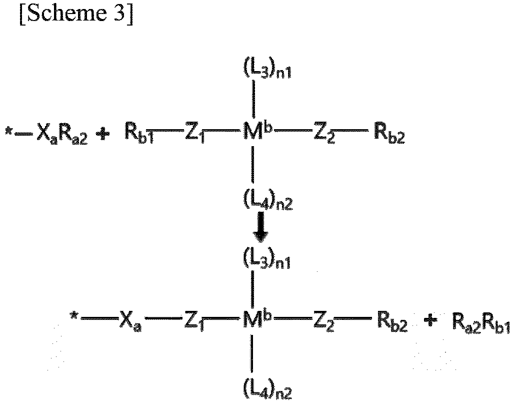

In Scheme 3, *-XₐRₐ₂ may be a surface functional group of the underlying layer, specifically, the surface functional group of the organic molecular layer O2 formed previously. The metal precursor of Formula 5B may self-assemble on the surface of the organic molecular layer O2 by reacting with the surface functional group of the previously formed organic molecular layer O2. During this process, Rₐ₂R_{b1} may be produced as a reaction by-product. After this, the remaining metal precursor and the reaction by-products may be purged in the purge step. In Scheme 3, each functional group may be the same as defined in Formula 4 and Formula 5B.

Unlike shown, when the photoreactive layer FL₂ is formed to include a plurality of metal monomolecular layers M2 (when n2 in Formula 1B is 2 or more), after performing the metal precursor dosing step and purge step according to Scheme 3 described above, a unit cycle comprising a reaction gas dosing step of dosing a reaction gas to react with the metal precursor chemically bonded to the underlying layer, a purge step of supplying a purge gas to purge unreacted reaction gas and reaction by-products, the metal precursor dosing step, and the purge step may be repeated. The reaction gas may be hydrogen, a gas containing oxygen (ex. O₂, O₃, H₂O), or a gas containing nitrogen (ex. NH₃).

An etch-resistant layer FL₃ may be formed on the photoreactive layer FL₂ or on the substrate before forming the light-absorbing layer FL₁. Forming the etch-resistant layer FL₃ may be performed using the atomic layer deposition method, specifically, the molecular layer deposition method.

As an example, the etch-resistant layer FL₃ may be formed by performing a cycle including forming an etch-resistant metal monolayer M3 and forming an organic molecular layer O3. The organic molecular layer O3 may be formed using the same or similar method to the method of forming the organic molecular layer O1 described in the light-absorbing layer FL₁. However, in the organic precursor dosing step of Scheme 1, -R₀ may be a surface functional group bonded to the surface on the etch target layer.

The etch-resistant metal monolayer M3 may be formed by performing a unit cycle including a metal precursor dosing step of dosing a metal precursor and chemically bonding the metal precursor to the underlying layer by self-assembly; and a purge step of purging unreacted metal precursors and reaction by-products by supplying a purge gas. The purge gas may be argon.

The metal precursor for forming the etch-resistant metal monolayer M3 may be represented by the following formula 5C.

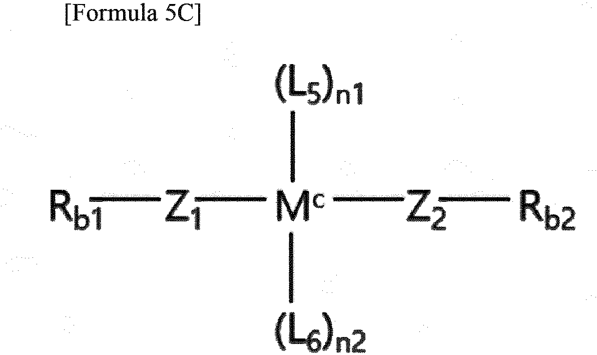

In Formula 5C, R_{b1} and R_{b2} may be, regardless of each other, a halogen group (ex. Cl, Br, or I), a C1 to C5 alkyl group, a C1 to C5 alkylsilylamino group, a C1 to C5 alkoxy group, a C1 to C5 alkylthio group, a C1 to C5 alkylseleno group, a C1 to C5 alkylamino group, or a C1 to C5 alkylphosphino group. The C1 to C5 alkyl groups may be substituted or unsubstituted linear or branched alkyl groups. Z₁, Z₂, L₅, L₆, n1, n2, and M^{c} are as defined in Formula 2C. In addition, in some cases, two of R_{b1}, R_{b2}, L₅, and L₆ may be combined with M^{c} to which they are directly or indirectly bonded to form heterocyclyl or heteroaryl. Alternatively, at least one of R_{b1} and R_{b2} may be coordinated to M^{c}.

Specific examples of metal precursors for forming the etch-resistant metal monolayer M3 may be as follows.

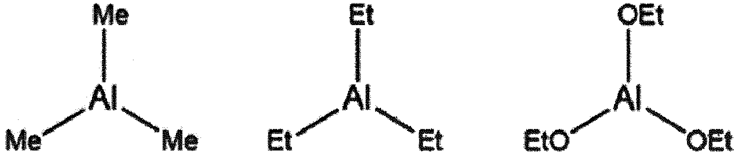

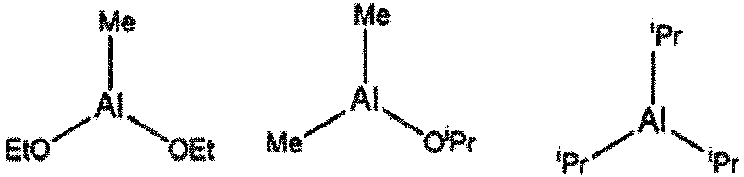

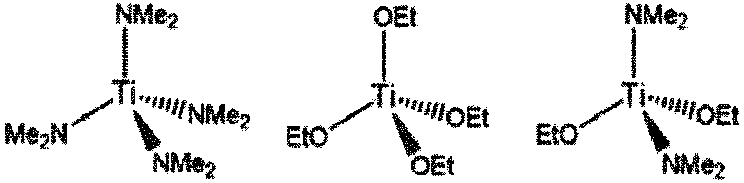

In the metal precursor dosing step, a reaction according to Scheme 4 below may occur.

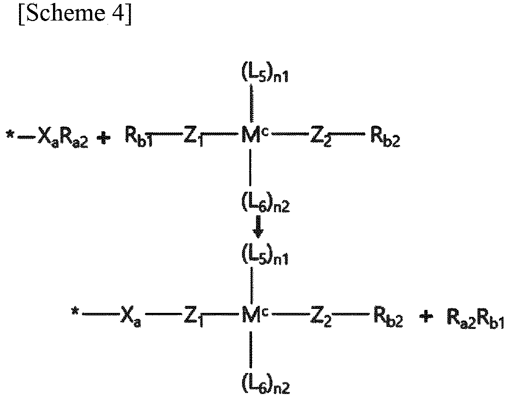

In Scheme 4, *-XₐRₐ₂ may be a surface functional group of the underlying layer, specifically, the surface functional group of the organic molecular layer O3 formed previously. The metal precursor of Formula 5C may self-assemble on the surface of the organic molecular layer O3 by reacting with the surface functional group of the previously formed organic molecular layer O3. During this process, Rₐ₂R_{b1} may be produced as a reaction by-product. After this, the remaining metal precursor and the reaction by-products may be purged in the purge step. In Scheme 4, each functional group may be the same as defined in Formula 4 and Formula 5C.

Unlike shown, when the etch-resistant layer FL₃ is formed to include a plurality of metal monomolecular layers M3 (when n3 in Formula 1C is 2 or more), after performing the metal precursor dosing step and purge step according to Scheme 4 described above, a unit cycle comprising a reaction gas dosing step of dosing a reaction gas to react with the metal precursor chemically bonded to the underlying layer, a purge step of supplying a purge gas to purge unreacted reaction gas and reaction by-products, the metal precursor dosing step, and the purge step may be repeated. The reaction gas may be hydrogen, a gas containing oxygen (ex. O₂, O₃, H₂O), or a gas containing nitrogen (ex. NH₃).

However, without being limited to the above, in another embodiment of the present invention, the multilayer molecular film photoresist 30 can be formed by performing a cycle including forming a metal molecular layer (MM of Formula 1) and forming an organic molecular layer (OM of Formula 1). In forming the organic molecular layer (OM of Formula 1), an organic molecule layer unit cycle may be performed. The organic molecule layer unit cycle may include an organic precursor dosing step of dosing an organic precursor of Formula 4 and chemically bonding the organic precursor to the underlying layer through self-assembly; and a purge step of supplying a purge gas to purge unreacted organic precursors and reaction by-products. The purge gas may be argon. In the organic precursor dosing step, a reaction according to Scheme 1 may occur.

In the step of forming the metal monomolecular layer (MM of Formula 1), a unit cycle including a metal precursor dosing step of dosing a metal precursor and chemically bonding the metal precursor to the underlying layer by self-assembly; and a purge step of purging unreacted metal precursors and reaction by-products by supplying a purge gas may be performed. The purge gas may be argon. The metal precursor may be represented by the following Formula 5.

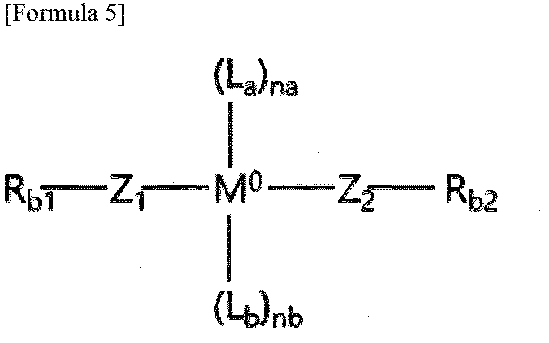

In Formula 5, R_{b1} and R_{b2} are, regardless of each other, a halogen group (ex. Cl, Br, or I), a C1 to C5 alkyl group, a C1 to C5 alkylsilylamino group, a C1 to C5 alkoxy group, a C1 to C5 alkylthio group, a C1 to C5 alkylseleno group, a C1 to C5 alkylamino group, or a C1 to C5 alkylphosphino group. The C1 to C5 alkyl groups may be substituted or unsubstituted linear or branched alkyl groups. Z₁, Z₂, Lₐ, L_{b}, na, nb, and M⁰ are as defined in Formula 2. In addition, in some cases, two of R_{b1}, R_{b2}, Lₐ, and L_{b} may be combined with M⁰ to which they are directly or indirectly bonded to form heterocyclyl or heteroaryl. Alternatively, at least one of R_{b1} and R_{b2} may be coordinated to M⁰.

In the metal precursor dosing step, a reaction according to Scheme 5 below may occur.

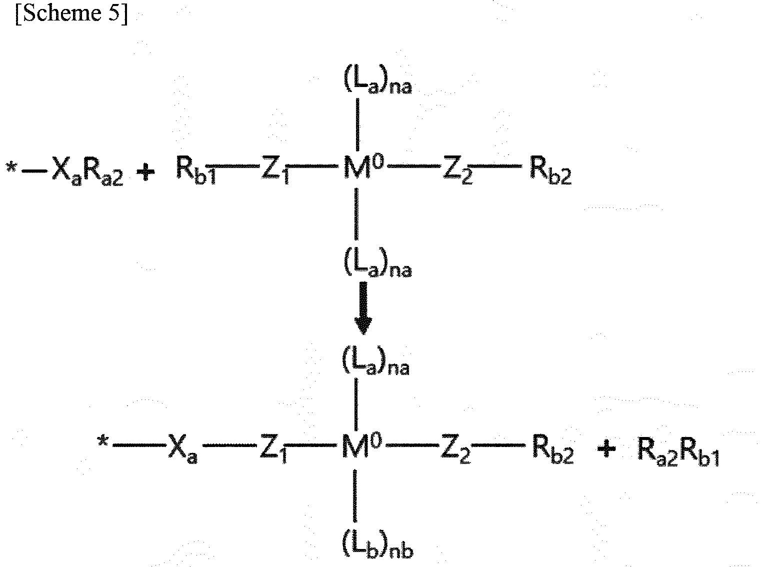

In Scheme 5, *-XₐRₐ₂ may be a surface functional group of the underlying layer, specifically, the surface functional group of the organic molecular layer OM formed previously. The metal precursor of Formula 5 may self-assemble on the surface of the organic molecular layer OM by reacting with the surface functional group of the previously formed organic molecular layer OM. During this process, Rₐ₂R_{b1} may be produced as a reaction by-product. After this, the remaining metal precursor and the reaction by-products may be purged in the purge step. In Scheme 5, each functional group may be the same as defined in Formula 4 and Formula 5.

Specifically, the metal precursor may be represented by the above formula 5A, 5B, or 5C. Additionally, specifically, in the metal precursor dosing step, the reaction according to Scheme 5 may be embodied as a reaction according to the above Schemes 2, 3, or 4.

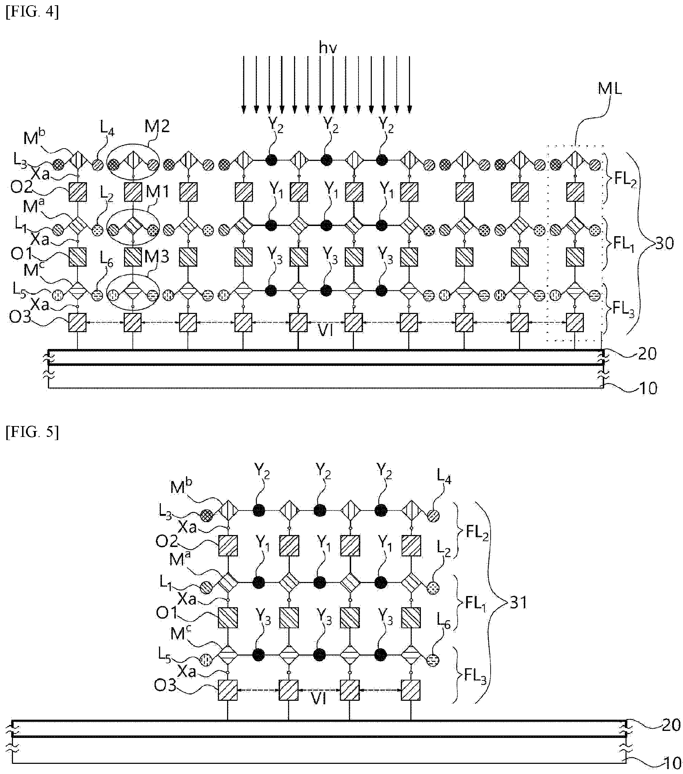

Referring to FIG. 4, radiation hv, specifically EUV or Ebeam, may be irradiated to a portion of the multilayer molecular film photoresist 30. In this case, M^{a}, a metal atom having a 4d or 5d orbital as an example of a d orbital in the light absorption layer FL₁, may absorb the radiation and generate secondary electrons. However, the present invention is not limited to this, and metal atoms or other elements in the photoreactive layer FL₂ and/or the etch-resistant layer FL₃ may also absorb radiation and generate secondary electrons.

Crosslinks may be formed between photoreactive inorganic single molecules M2 in adjacent molecular lines ML by secondary electrons generated in the light absorption layer FL₁. Specifically, M^{b}-L₄ and L₃-M^{b} in the photoreactive inorganic single molecules M2 adjacent to each other may react by the secondary electrons to form M^{b}-Y₂-M^{b} bond. Y₂ may be O, S, Se, N, or P. Additionally, crosslinks may be formed between the light-absorbing inorganic single molecules M1 in adjacent molecular lines ML by secondary electrons generated in the light-absorbing layer FL₁. Specifically, M^{a}-L₂ and L₁-M^{a} bonds in the light-absorbing inorganic single molecules M1 may react with the secondary electrons to form M^{a}-Y₁-M^{a} bond. Y₁ may be O, S, Se, N, or P. In addition, crosslinks may also be formed between the etch-resistant inorganic single molecules M3 in adjacent molecular lines ML by secondary electrons generated in the light absorption layer FL₁. Specifically, M^{c}-L₆ and L₅-M^{c} bonds in the etch-resistant inorganic single molecules M3 may react with the secondary electrons to form M^{c}-Y₃-M^{c} bond. Y₃ may be O, S, Se, N, or P.

Referring to FIG. 5, the multilayer molecular film photoresist 30 exposed to radiation may be exposed to a developer. In this case, the portion where crosslinks are not formed between the inorganic single molecules (M1, M2, and M3) in the adjacent molecular lines ML may removed by the developer to form a multilayer molecular film photoresist pattern 31. The developer may be a developing solution, such as water, isopropyl alcohol (IPA), methyl isobutyl ketone (MIBK), tetramethylammonium hydroxide (TMAH), or a developing gas, such as CF₄, Ar, Oz, CHF₃, etc., or a plasma generated from this.

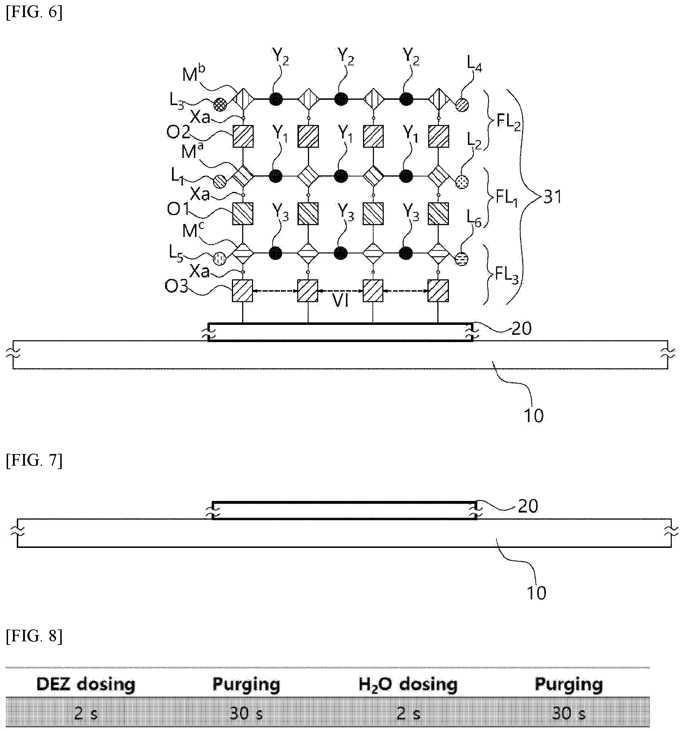

Referring to FIG. 6, the etch target layer 20 may be etched using the multilayer molecular film photoresist pattern 31 as a mask. As an example, this etching may be plasma etching. The etching resistance of the multilayer molecular film photoresist pattern 31 may be increased due to the M^{c}-Y₃-M^{c} bond between the etch-resistant inorganic single molecules M3, allowing the etch target layer 20 to be selectively etched.

Referring to FIG. 7, the multilayer molecular film photoresist pattern 31 can be removed. This can be accomplished using the ashing method.

Referring again to FIG. 3, molecular layer deposition equipment for manufacturing a multilayer molecular film photoresist will be described. Except as described later, what has been described with reference to FIGs. 1, 2a, 2b, and 3 will be referred to.

The molecular layer deposition equipment according to an embodiment of the present invention may perform a plurality of cycles including forming a metal monomolecular layer (MM in Formula 1) and forming an organic molecular layer (OM in Formula 1). Specifically, the number of cycles may be indicated by l of Formula 1.

In forming the organic molecular layer (OM in Formula 1), an organic molecular layer unit cycle may be performed. The organic molecular layer unit cycle may include an organic precursor dosing step of dosing an organic precursor of Formula 4 and chemically bonding the organic precursor to the underlying layer through self-assembly; and a purge step of supplying a purge gas to purge unreacted organic precursors and reaction by-products. The purge gas may be argon. In the organic precursor dosing step, a reaction according to Scheme 1 may occur.

In the step of forming the metal monomolecular layer (MM of Formula 1), a unit cycle including a metal precursor dosing step of dosing a metal precursor of Formula 5 and chemically bonding the metal precursor to the underlying layer by self-assembly; and a purge step of purging unreacted metal precursors and reaction by-products by supplying a purge gas may be performed. The purge gas may be argon. In the metal precursor dosing step, a reaction according to Scheme 5 may occur. Specifically, the metal precursor may be represented by Formula 5A, 5B, or 5C. Additionally, specifically, a reaction according to Scheme 2, 3, or 4 may occur in the metal precursor dosing step.

The molecular layer deposition equipment according to one embodiment of the present invention specifically performs a cycle including forming a light-absorbing metal monolayer M1 and forming an organic molecular layer O1 on a substrate multiple times to form a light absorption layer FL₁. The number of cycles may be the number represented by 11 in Formula 1A.

In the step of forming the organic molecular layer O1, an organic precursor dosing step of dosing the organic precursor of Formula 4 and chemically bonding the organic precursor to the lower layer through self-assembly; and a purge step of purging unreacted organic precursors and reaction products by supplying a purge gas. The purge gas may be argon. In the organic precursor dosing step, a reaction according to Scheme 1 may occur.

The step of forming the light-absorbing metal monolayer M1 includes dosing a metal precursor of Formula 5A and chemically bonding the metal precursor to the lower layer by self-assembly; and a purge step of purging unreacted metal precursors and reaction products by supplying a purge gas. The purge gas may be argon. In the metal precursor dosing step, a reaction according to Scheme 2 may occur.

On the light absorption layer FL₁ or on the substrate before forming the light absorption layer FL₁, a cycle including forming a photoreactive metal monolayer M2 and forming an organic molecular layer O2 may be performed multiple times to form a photoreactive layer FL₂. The number of cycles may be the number represented by l2 in Formula 1B. The step of forming the organic molecular layer O2 can be performed using the same or similar method as described for the light absorption layer FL₁.

The step of forming a photoreactive metal monolayer M2 includes dosing a metal precursor of Formula 5B and chemically bonding the metal precursor to the lower layer by self-assembly; and a purge step of purging unreacted metal precursors and reaction products by supplying a purge gas. The purge gas may be argon. In the metal precursor dosing step, a reaction according to Scheme 3 may occur.

On the light absorption layer FL₁ or on the substrate before forming the light absorption layer FL₁, a cycle including forming an etch-resistant metal monolayer M3 and forming an organic molecular layer O3 multiple times to form an etch-resistant layer FL₃. The number of cycles may be the number represented by l3 in Formula 1C. The step of forming the organic molecular layer O3 can be performed using the same or similar method as described for the light absorption layer FL₁.

The step of forming the etching-resistant metal monolayer M3 includes dosing a metal precursor of the formula 5C and chemically bonding the metal precursor to the lower layer by self-assembly; and a purge step of purging unreacted metal precursors and reaction products by supplying a purge gas. The purge gas may be argon. In the metal precursor dosing step, a reaction according to Scheme 4 may occur.

As described above, the multilayer molecular film photoresist 30 according to an embodiment of the present invention may be formed by self-assembly of inorganic single molecules and organic single molecules connected by bonds within the molecular lines, so that each molecular line can grow upward over the substrate without being entangled or tilted, and the molecular lines can be uniformly arranged in the horizontal direction.

In this case, the gap between the molecular lines (D in FIG. 1 or FIG. 4) may be very small, such as 1 nm or less, specifically 0.5 nm or less. In addition, due to the separation between molecular lines rather than particles during exposure and development, the Line Edge Roughness (LER), which refers to the roughness of the side of the pattern, can be very low, for example, at 1.2 nm or less, and the resolution can be very enhanced, for example, to 6 nm or less. In addition, the multilayer molecular film photoresist 30 including a light-absorbing inorganic single molecule M1 having an inorganic atom with a very high light absorption rate for EUV, specifically a metal atom with a 4d or 5d orbital, can exhibit high photosensitivity (ex. 10 mJ/cm²) with low stochastic failure even for EUV with low photon density.

Hereinafter, a preferred experimental example is presented to help understanding of the present invention. However, the following experimental examples are only to aid the understanding of the present invention, and the present invention is not limited by the following experimental examples.

FIG. 8 shows a unit cycle configuration for forming an inorganic molecular layer.

Referring to FIG. 8, a unit cycle including dosing DEZ (diethylzinc) into the chamber for 2 seconds, purging the chamber for 30 seconds, dosing water (H₂O) for 2 seconds, and purging the chamber for 30 seconds was performed multiple times (30 times) to form a ZnO inorganic molecular layer.

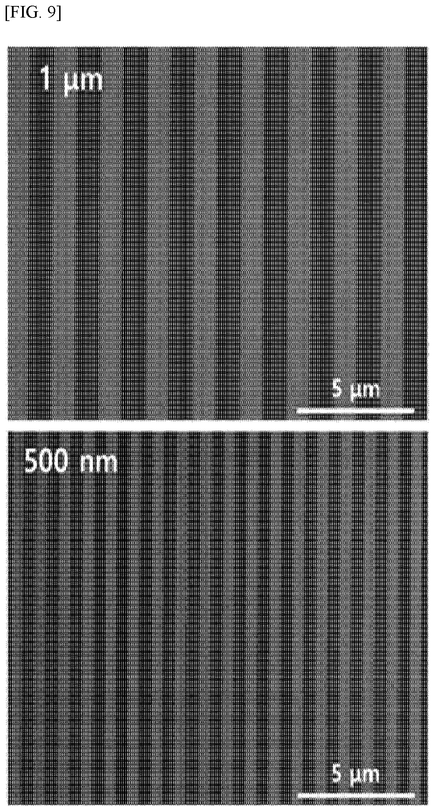

FIG. 9 is an SEM image taken after patterning the vertically designed inorganic multilayer molecular film photoresist formed with reference to FIG. 8. Specifically, after irradiating an e-beam on a vertically designed inorganic multilayer molecular film formed with reference to FIG. 8 under a voltage of 100 kV and a dose of 2500 uC/cm², the film was developed by ultrasonic treatment in TMAH (tetramethylammonium hydroxide) in H₂O for 2 minutes.

Referring to FIG. 9, it can be seen that a pattern with a line width of 1 µm and a pattern with a line width of 500 nm were clearly formed.

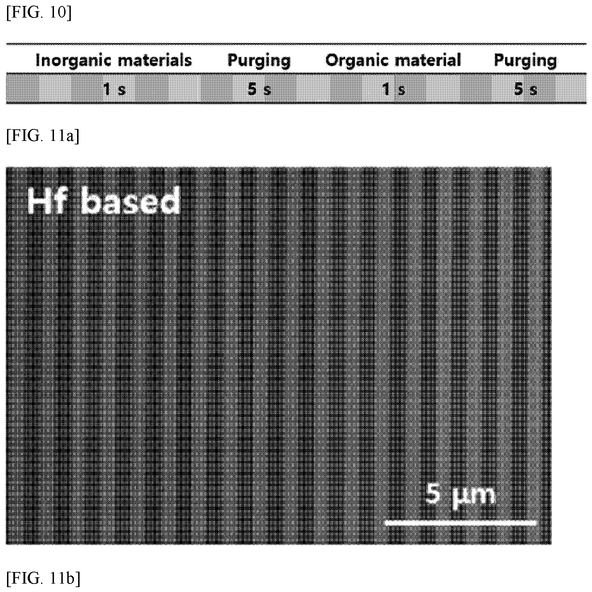

FIG. 10 shows an example of a unit cycle configuration for forming a multilayer molecular film photoresist having a vertical molecular line structure.

Referring to FIG. 10, a substrate was loaded into a chamber, and the substrate temperature was heated to 100-300 °C, specifically 100-150 °C. Tetrakisdimethylamido hafnium, tetrakisdimethylamido titanium, trimethyl aluminum, or DEZ(diethylzinc) as a metal precursor was dosed to the substrate through a gas inlet without a carrier gas, until the pressure in the chamber reached 0.01 to 10 torr, specifically 0.005 to 0.5 torr for 1 second. Afterwards, the chamber was purged for 5 seconds. 4-mercaptophenol as an organic precursor was dosed to the substrate through the gas inlet without a carrier gas, until the pressure in the chamber reached 0.01 to 10 torr, specifically 0.01 torr for 1 second. Afterwards, the chamber was purged for 5 seconds. A unit cycle including the metal precursor dosing step, the purging step, the organic precursor dosing step and the purging step was repeated for multiple times (approximately 30 times) to form a multilayer molecular film photoresist with a thickness of approximately 20 nm.

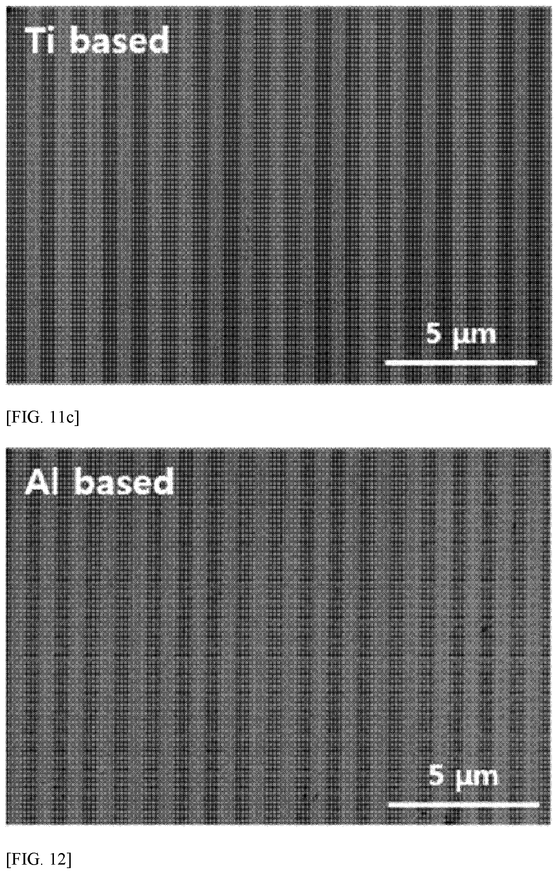

FIGs. 11a, 11b, and 11c are SEM images taken after patterning the photoresist formed using the method described with reference to FIG. 10. Specifically, the photoresist formed using the method described with reference to FIG. 10 was exposed to e-beam under conditions of a voltage of 100 kV, 100 pA, and a dose of 2500 uC/cm², and then developed by ultrasonicating in TMAH (tetramethylammonium hydroxide) in H₂O for 2 minutes.

Referring to FIGs. 11a, 11b, and 11c, it can be seen that a pattern with a half pitch of 500 nm was clearly formed. The remained portion of the photoresist is the exposed portion, so the photoresist according to this embodiment can be defined as a negative photoresist.

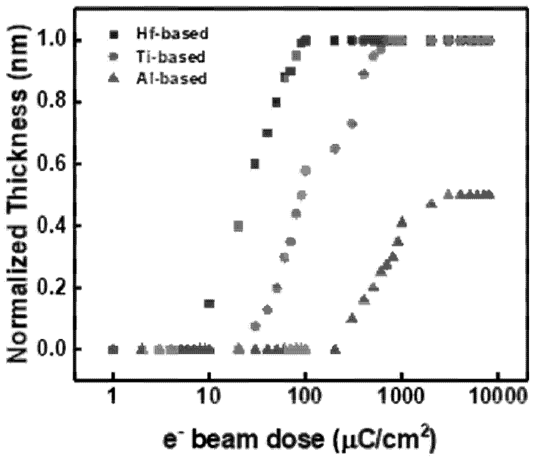

FIG. 12 is a graph showing the sensitivity to electron beam of the photoresist formed using the method described with reference to FIG. 10. Specifically, the photoresist formed using the method described with reference to FIG. 10 was exposed to e-beam under conditions of a voltage of 100 kV, 100 pA, and a dose of 1 to 10,000 uC/cm², and then developed by ultrasonic treatment in TMAH (tetramethylammonium hydroxide) in H₂O for 2 minutes, and the thickness of the pattern was measured according to the exposure amount.

Referring to FIG. 12, the normalized thickness of the negative photoresist in this experiment is indicated as 1nm when the thickness immediately after deposition is maintained even after development, and the multilayer molecular film photoresist formed using the Hf precursor can be seen to have the best sensitivity as it shows a normalized thickness of 1 nm at the lowest e-beam dose.

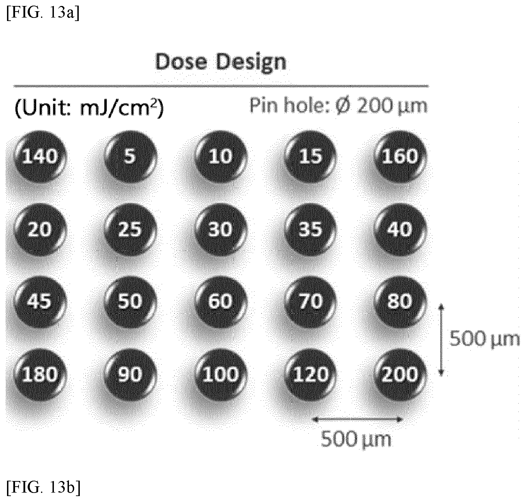

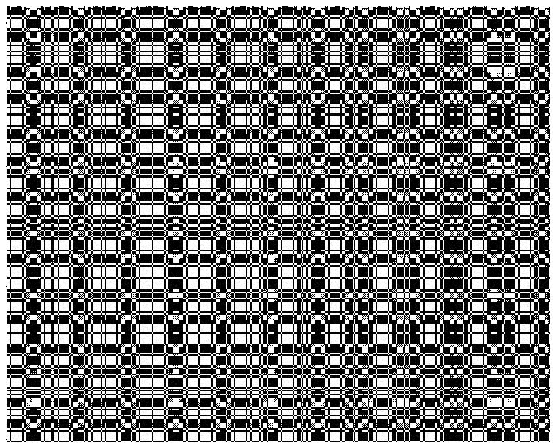

FIG. 13a is a schematic diagram showing the form and dose conditions of EUV irradiation, and FIG. 13b shows an optical photograph of a photoresist pattern obtained when EUV as shown in FIG. 13a is irradiated to a photoresist using an Hf precursor formed using the method described with reference to FIG. 10. Specifically, FIG. 13b is a photograph of a photoresist pattern obtained by exposing the photoresist using an Hf precursor formed using the method described with reference to FIG. 10 to an EUV pattern as shown in FIG. 13a and then developing by ultrasonicating it in TMAH (tetramethylammonium hydroxide) in H₂O for 2 minutes.

Referring to FIGs. 13a and 13b, the photoresist obtained using Hf precursor as the metal precursor has a thickness of about 20 nm immediately after deposition, and has a thickness of about 10 nm or more after being exposed to EUV at a dose of about 40 mJ/cm² or more and developed. From this, it can be seen that the EUV sensitivity of the Hf-based photoresist is 40 mJ/cm².

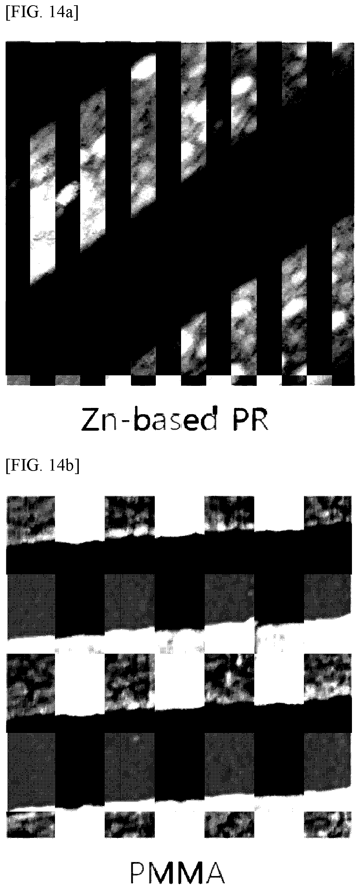

FIG. 14a is an AFM (atomic force microscopy) image obtained after electron beam exposure and development of a photoresist using a Zn precursor formed using the method described with reference to FIG. 10, and FIG. 14b is an AFM (atomic force microscopy) image obtained after electron beam exposure and development of a PMMA photoresist. The PMMA photoresist was obtained by applying a solution of PMMA dissolved in chlorobenzene on a substrate, then irradiating it with an electron beam, and removing the irradiated part through development to obtain a pattern. The two photoresists were commonly irradiated with electron beam under the conditions of voltage of 100 kV, 100 pA, and dose of 2500 uC/cm². The photoresist using the Zn precursor was sonicated in TMAH (tetramethylammonium hydroxide) in H₂O for 2 minutes, and the unexposed portions were removed.

Referring to FIGs. 14a and 14b, it can be seen that the photoresist using the Zn precursor has lower line edge roughness than the PMMA photoresist.

## Claims

1. A multilayer molecular film photoresist comprising:
a plurality of molecular lines extending upwards above a substrate arranged in the horizontal direction,
wherein each of the molecular lines includes a plurality of inorganic single molecules and an organic single molecule sandwiched between at least some of the inorganic single molecules, and these single molecules are connected by bonds.

2. The multilayer molecular film photoresist of Claim 1, wherein Van der Waals interaction occurs between the organic single molecules in horizontally adjacent molecular lines among the molecular lines.

3. The multilayer molecular film photoresist of Claim 2, wherein the van der Waals interaction is a π-π bond.

4. The multilayer molecular film photoresist of Claim 1, wherein, within the each molecular line, the inorganic single molecules and the organic single molecules are alternately stacked and connected by bonds.

5. The multilayer molecular film photoresist of Claim 1,
wherein among the inorganic single molecules provided in the molecular lines, identical inorganic single molecules are located at the same level in the horizontal direction to form an inorganic monomolecular layer, and,
among the organic single molecules provided in the molecular lines, identical organic single molecules are located at the same level in the horizontal direction to form an organic monomolecular layer.

6. The multilayer molecular film photoresist of Claim 5, wherein the multilayer molecular film photoresist has at least one layer of a light-absorbing layer including light-absorbing inorganic single molecules, a photoreactive layer including photoreactive inorganic single molecules, and an etch-resistant layer including etch-resistant inorganic single molecules.

7. The multilayer molecular film photoresist of Claim 6, wherein the light-absorbing inorganic single molecule has an inorganic single molecule having a metal element having a d orbital.

8. The multilayer molecular film photoresist of Claim 7, wherein The metal element having the d orbital is Sn, Sb, Te, or Bi.

9. The multilayer molecular film photoresist of Claim 6, wherein the photoreactive inorganic molecule has a metal element such as Zr, Al, Hf, Zn, or In.

10. The multilayer molecular film photoresist of Claim 6, wherein the etch-resistant inorganic single molecule has a metal element such as Al, Ti, W, Zn, or Cu.

11. A multilayer molecular film photoresist comprising:
a plurality of molecular lines each extending upwards above a substrate and arranged in the horizontal direction,
wherein each of the molecular lines has a portion represented by the following Formula 1: 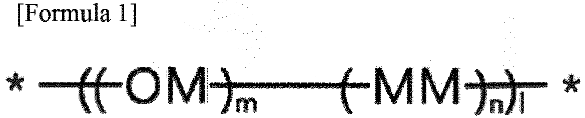
in Formula 1, one of the *s is a bond with a functional group in an underlying portion, the other is a bond with a functional group in an upper portion,
MM is an inorganic single molecule containing a metal element,
OM is an organic single molecule,
m is 1 to 2, n is 1 to 2, and l is 1 to 1000.

12. The multilayer molecular film photoresist of Claim 11, wherein the organic single molecule is represented by the following Formula 3: 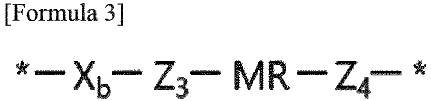
in Formula 3, one of the *s is a bond with a functional group in an underlying portion, the other is a bond with a functional group in an upper portion,
X_{b} is O, S, Se, NR (R is H or CH₃) or PR (R is H or CH₃),
MR is a substituted or unsubstituted aromatic ring, a C1 to C18 substituted or unsubstituted linear alkylene group, or a C1 to C18 substituted or unsubstituted branched alkylene group,
Z₃ and Z₄, regardless of each other, is a bond, a substituted or unsubstituted linear alkylene group of C1 to C5, or a substituted or unsubstituted branched alkylene group of C1 to C5 when MR is the aromatic ring,
Z₃ and Z₄ is bonds when MR is the alkylene group.

13. The multilayer molecular film photoresist of Claim 11, wherein MM is a light-absorbing inorganic single molecule containing a metal element having a d orbital, a photoreactive inorganic single molecule containing Zr, Al, Hf, Zn, or In, or an etch-resistant inorganic single molecule containing Al, Ti, Cu, W, or Zn.

14. The multilayer molecular film photoresist of Claim 11, wherein the layer represented by Formula 1 is a layer represented by Formula 1A below: 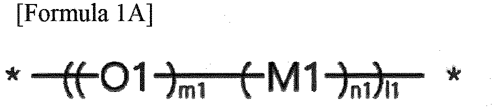
in Formula 1A, one of the *s is a bond to a functional group in an underlying layer, and the other one is a bond to a functional group in an upper layer,
M1 is a light-absorbing inorganic single molecule containing a metal element having a d orbital,
O1 is an organic single molecule,
m1 is 1 to 2, n1 is 1 to 2, and l1 is 1 to 1000.

15. The multilayer molecular film photoresist of Claim 14, wherein each of the molecular lines has a layer represented by the following Formula 1B above or below the layer represented by the Formula 1A: 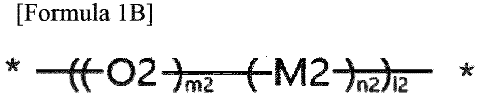
in Formula 1B, one of the *s is a bond to a functional group in an underlying layer, and the other one is a bond to a functional group in an upper layer,
M2 is a photoreactive inorganic single molecule containing Zr, Al, Hf, Zn, or In,
O2 is an organic single molecule,
m2 is 1 to 2, n2 is 1 to 2, and l2 is 1 to 1000.

16. The multilayer molecular film photoresist of Claim 14, wherein each of the molecular lines has a layer represented by the following Formula 1C above or below the layer represented by the Formula 1A: 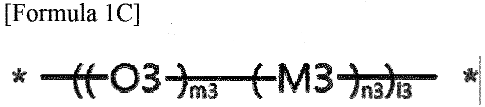
in Formula 1C, one of the *s is a bond to a functional group in an underlying layer, and the other one is a bond to a functional group in an upper layer,
M3 is a etch-resistant inorganic single molecule containing Al, Ti, Cu, W, or Zn,
O3 is an organic single molecule,
m3 is 1 to 2, n3 is 1 to 2, and l3 is 1 to 1000.

17. The multilayer molecular film photoresist of Claim 1 or Claim 11, wherein the multilayer molecular film photoresist is a photoresist for EUV.

18. A multilayer molecular film photoresist deposition equipment providing a multilayer molecular film photoresist including a plurality of molecular lines arranged in the horizontal direction, and the molecular lines each extend upwards above a substrate,
wherein the multilayer molecular film photoresist is formed by performing multiple cycles including forming a metal monomolecular layer and forming an organic molecular layer on a substrate, thereby each of the molecular lines having a portion represented by the following Formula 1: 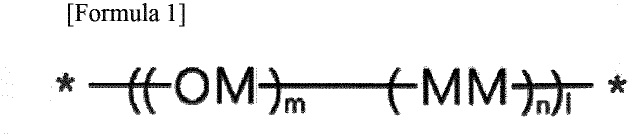
in Formula 1, one of the *s is a bond with a functional group in an underlying portion, the other is a bond with a functional group in an upper portion,
MM is an inorganic single molecule containing a metal element,
OM is an organic single molecule,
m is 1 to 2, n is 1 to 2, and l is 1 to 1000.

19. The multilayer molecular film photoresist deposition equipment of Claim 18, wherein MM is a light-absorbing inorganic single molecule containing a metal element having a d orbital, a photoreactive inorganic single molecule containing Zr, Al, Hf, Zn, or In, or an etch-resistant inorganic single molecule containing Al, Ti, Cu, W, or Zn.

20. The multilayer molecular film photoresist deposition equipment of Claim 18, wherein the organic single molecule is represented by the following Formula 3: 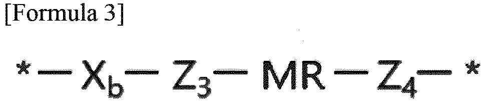
In Formula 3, one of the *s is a bond with a functional group in an underlying portion, the other is a bond with a functional group in an upper portion,
X_{b} is O, S, Se, NR (R is H or CH₃) or PR (R is H or CH₃),
MR is a substituted or unsubstituted aromatic ring, a C1 to C18 substituted or unsubstituted linear alkylene group, or a C1 to C18 substituted or unsubstituted branched alkylene group,
Z₃ and Z₄, regardless of each other, is a bond, a substituted or unsubstituted linear alkylene group of C1 to C5, or a substituted or unsubstituted branched alkylene group of C1 to C5 when MR is the aromatic ring,
Z₃ and Z₄ is bonds when MR is the alkylene group.
